# EUROPEAN PATENT APPLICATION

(11) **EP 4 079 931 A1**
(43) Date of publication of application: **26.10.2022**
(21) Application number: 20901488.5
(22) Date of filing: 09.06.2020
(51) Int. Cl.: C23C 16/458

(54) **COATING DEVICE AND COATING METHOD THEREOF**

(30) Priority: 18.12.2019 CN 201911310683
(71) Applicant: Jiangsu Favored Nanotechnology Co., Ltd., Yuqi Industry Park, Huishan District Wuxi Jiangsu 214000 (CN)
(72) Inventor: ZONG, Jian, Wuxi, Jiangsu 214112 (CN)
(74) Representative: Mewburn Ellis LLP
(86) International application number: PCT/CN2020/095075
(87) International publication number: WO 2021/120540

(57) **Abstract**

A coating device, for coating multiple substrates, and comprising a chamber body having a reaction chamber, a support frame, a monomer release source and a plasma excitation source. The monomer release source has at least one release inlet for introducing a coating-forming material into the reaction chamber of the chamber body. The plasma excitation source is provided in a middle region of the reaction chamber of the chamber body so as to excite the coating-forming material; the multiple substrates are adaptively arranged around the plasma excitation source in the chamber body, so as to increase the coating uniformity and deposition rate on the surfaces of the substrates.

## Description

### TECHNICAL FIELD

The present disclosure relates to coating deposition, and more particularly to a coating apparatus and coating method for applying and forming a coating on a substrate which is adapted for being arranged between a discharge source of a coating forming material and a plasma generation source to avoid an excessive decomposition of the coating forming material during a coating forming process.

### BACKGROUND

A coating apparatus is arranged for forming a polymer nanocoating or film layer on a surface of a substrate, which is made of a material including, but is not limited to, metal, glass, ceramic, polymer, fabrics, fibers, powder, and semiconductor, to improve various properties of the substrate such as hydrophobic, hydrophilic, oleophobic, anti-rust, mildew proof, moisture barrier, electrical and thermal conductive, biomedical, optical, and tribological performances.

A typical coating apparatus implementing a PECVD (Plasma Enhanced Chemical Vapor Deposition) process is generally constructed for introducing a gaseous coating forming material into a vacuum chamber, in which one or more substrates are disposed, to form a polymer layer on the surface of the substrate. More specifically, the gaseous coating forming material, which may include, but is not limited to, an organic material, an organosilicon material, an inorganic material, and a combination thereof, is a gaseous monomer or monomer vapor which is activated to be in a plasma state by discharging electrical power to the monomer to produce various types of reactive precursor species. And then, reactions between the reactive precursor species and the monomer, or between the reactive precursor species themselves take place and the polymer film is then deposited and formed on the surface of the substrate.

The monomer should be excited to produce the reactive precursor species, but an excessive exposure of the monomer in the plasma exciting media can result in an excessive decomposition of the monomer, so that a deposition velocity and a uniformity of the polymer coating is adversely affected.

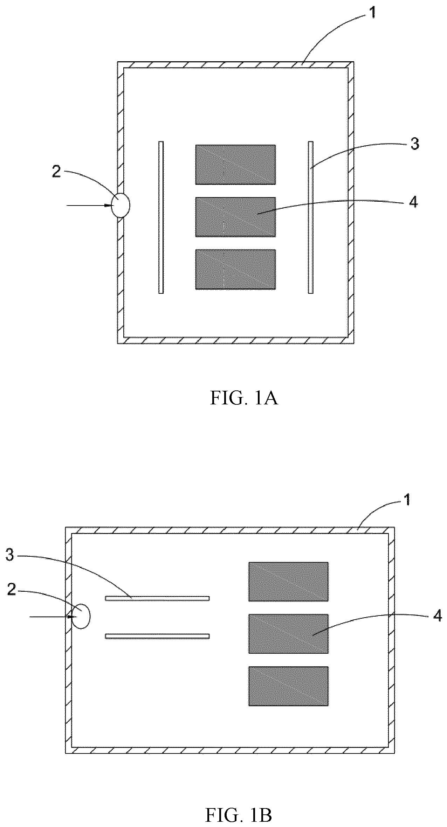

Referring to FIG. 1A of the drawings, a conventional coating apparatus includes a chamber body 1, a discharge source 2 of coating forming material for introducing the coating forming material into the chamber body 1, and a plasma generation source 3 for applying an electrical power to the coating forming material so as to excite the coating forming material. As shown in the drawings, one or more substrates 4 are disposed between opposite electrodes of the plasma generation source 3. The coating forming material disperses into the space between opposite electrodes of the plasma generation source 3 to undergo an exciting process for generating the reactive precursor species. Since the coating forming material should be excited in the effect of the plasma generation source 3 and then deposit on the substrates 4 which are placed in the plasma generation source 3, an excessive decomposition of the coating forming material may occur. In addition, the exposure of the substrates 4 between the electrodes of the plasma generation source 3 may also result in a damage to the substrates 4.

Referring to FIG. 1B of the drawings, another conventional coating apparatus includes a chamber body 1, a discharge source 2 of coating forming material, and a plasma generation source 3 which is placed between the discharge source 2 of coating forming material and the substrates 4 to be coated. During the coating method, the coating forming material is required to pass through the space between opposite electrodes of the plasma generation source 3 to implement the exciting process for generating the reactive precursor species before reaching to the substrates 4.

US Pat. NO. US7,968,154B2, entitled "Atomization of a precursor into an excitation medium for coating a remote substrate" and US Pat. No. US8,029,872B2, entitled "Application of a coating forming material onto at least one substrate" have disclosed such above coating apparatus including an atomized monomer source and a plasma excitation medium. The substrates and the atomized monomer source are respectively located on two opposite sides of the plasma excitation medium that the atomized monomer source passes through the plasma excitation medium, and then is deposited on the surfaces of the substrates on the opposite side of the plasma excitation medium to form the polymer coating. It thus can be seen that the atomized monomer can only be deposited on the surfaces of the substrates after passing through the plasma excitation medium. The plasma excitation medium can cause a relative large portion of the atomized monomer to decompose for a relatively long time, so that excessive decomposition of the atomized monomer may take place, and thus the formed coating is hard to retain the chemical properties of the atomized coating forming material.

US App. NO. US16/095179 entitled "Multi-source low-power low-temperature plasma polymerized coating device and method" has disclosed a coating device by replacing a single high-frequency discharge source with large area and high power by combining a plurality of high-frequency discharge sources with a small area and a low power. However, this method still somehow excessively destroys a chemical monomer structure of the monomer and causes unsatisfied quality of the formed polymer coating, and the structure of the device is relatively complicated and difficult for assembling.

### SUMMARY

The present disclosure is advantageous in that it provides a coating apparatus and coating method, wherein a substrate is adapted to be formed with a coating on a surface thereof without an excessive decomposition of a coating forming material during a plasma polymerization coating method.

Another advantage of the present disclosure is to provide a coating apparatus and coating method, wherein the substrate to be coated is adapted for being placed between a monomer discharge source for introducing the coating forming material into a chamber body and a plasma generation source for exciting the coating forming material, so that the coating forming material which is a gaseous monomer or monomer vapor is not required to pass through the plasma generation source before reaching to the substrate, and thus the excessive decomposition of the coating forming material is reduced.

Another advantage of the present disclosure is to provide a coating apparatus and coating method, wherein the substrate to be coated is adapted to be placed at a position having a smaller distance away from the monomer discharge source than the plasma generation source in such a manner that at least a portion of the coating forming material reaches an area for positioning the substrate before reaching to the plasma generation source, so that not all of the coating forming material is required to pass through the plasma generation source before reaching to the substrate.

Another advantage of the present disclosure is to provide a coating apparatus and coating method, wherein the configuration of the monomer discharge source, a supporting rack for supporting the substrate, and the plasma generation source is able to maintain a desired level of reactions between reactions between reactive precursor species, which are produced by a proportion of the monomer reaching to the plasma generation source, and another proportion of the monomer which has not decomposed into the reactive precursor species, so as to increase a quality of the formed polymer coating on the surface of the substrate.

Another advantage of the present disclosure is to provide a coating apparatus and coating method, wherein according to some embodiments, the substrate to be coated can be supported on the supporting rack which is movable between the monomer discharge source and the plasma generation source, so as to adjust the distance between the substrate and the plasma generation source, so as to control and adjust a composition of a formed polymer material which is deposited on the surface of the substrate.

Another advantage of the present disclosure is to provide a coating apparatus and coating method, wherein according to some embodiments, the plasma generation source is provided at a substantial central position of a reaction chamber of the chamber body while a plurality of the substrates can be arranged around the plasma generation source, wherein the coating forming material, which can be discharged from the monomer discharge source at a position adjacent to an inner wall of the chamber body, radially disperses into the reaction chamber and has to pass through the area for placing the substrate before reaching to the plasma generation source.

Another advantage of the present disclosure is to provide a coating apparatus and coating method, wherein according to some embodiments, the plasma generation source is provided at the central position of the reaction chamber of the chamber body for exciting the coating forming material dispersed into the reaction chamber, so as to increase the uniformity of a concertation of reactive precursor species around the plasma generation source, so as to increase a quality of the formed polymer coating on the surface of the substrate.

Another advantage of the present disclosure is to provide a coating apparatus and coating method, wherein according to some embodiments, the supporting rack for supporting the substrate can be embodied to include a rotation rack that rotates with respect to the plasma generation source in the reaction chamber to change a relative position between the substrate and the plasma generation source, and also functions to stir the gaseous coating forming material dispersed into the reaction chamber, so as to increase a uniformity of the polymer coating formed on the surface of the substrate.

Another advantage of the present disclosure is to provide a coating apparatus and coating method, wherein according to some embodiments, the supporting rack for supporting the substrate can be embodied to include a rotation rack that rotates in the reaction chamber to stir the gaseous monomer and the reactive precursor species, so as to evenly mix the monomer and the reactive precursor species, so that adequate reactions of the reactive precursor species and the monomer are achieved.

Another advantage of the present disclosure is to provide a coating apparatus and coating method, wherein according to some embodiments, the plasma generation source can be mounted to a movable rack of the supporting rack so that the plasma generation source is able to move in the reaction chamber along with the movement of the rotation rack so as to provide a relatively even electrical exciting environment for exciting the coating formation material dispersed into the reaction chamber of the chamber body.

Another advantage of the present disclosure is to provide a coating apparatus and coating method, wherein according to some embodiments, when the plasma generation source is mounted to the movable rack, the relative movement of the plasma generation source and the movable rack can be avoided, so that the movement of the movable rack will not provide a shielding effect to the plasma generation source.

Another advantage of the present disclosure is to provide a coating apparatus and coating method, wherein according to some embodiments, a plurality of the substrates is able to move with respect to the plasma generation source which is arranged at the central position of the reaction chamber, so as to adjust a distance between each substrate and the plasma generation source, so as to control the quality of the polymer coating on the surface of the substrate.

Another advantage of the present disclosure is to provide a coating apparatus and coating method, wherein according to some embodiments, a relative movement between the substrate and the monomer discharge source of the coating forming material is controllable, so that adequate reactions of the reactive precursor species and the monomer allow the polymer coating with high quality to be deposited on the surface of the substrate.

Another advantage of the present disclosure is to provide a coating apparatus and coating method, wherein according to some embodiments, a relative movement between the substrate and the plasma generation source is controllable to control the amount of the reactive precursor species reaching to the substrate, rendering adequate reactions of the reactive precursor species and the monomer before the formation of the polymer coating on the surface of the substrate.

Another advantage of the present disclosure is to provide a coating apparatus and coating method, wherein according to some embodiments, the substrate is adapted for being supported on a carrier rack which is operable to rotate about its central axis and is also rotating along with an rotation rack, so as to adjust a relative position between the substrate and the plasma generation source, so as to adjust the amount of the reactive precursor species and the monomer reaching to the substrate for forming the polymer coating on the surface of the substrate.

Another advantage of the present disclosure is to provide a coating apparatus and coating method, wherein the substrate to be coated is adapted for being arranged at an outer side of the plasma generation source, so as to avoid a damage to the substrate by the plasma generation source during the coating process.

Another advantage of the present disclosure is to provide a coating apparatus and coating method, wherein the coating is evenly formed on the surface of the substrate, and the deposition velocity is increased.

Another advantage of the present disclosure is to provide a coating apparatus and coating method, wherein the amount of the coating forming material used for forming the polymer coating is increased, so as to avoid waste and reduce cost.

Another advantage of the present disclosure is to provide a coating apparatus and coating method, wherein branching and cross-linking in a molecular structure of the polymer coating are enhanced, and an integrity of the molecular structure of the polymer coating is achieved, so as to ensure a good performance of the polymer coating.

Another advantage of the present disclosure is to provide a coating apparatus and coating method, wherein the apparatus is simple in structure, easy for operation and maintenance.

Additional advantages and features of the disclosure will become apparent from the description which follows, and may be realized by means of the instrumentalities and combinations particularly pointing out in the appended claims.

According to the present disclosure, the foregoing and other objects and advantages are attained by a coating apparatus for coating a substrate, wherein the coating apparatus includes a chamber body, a monomer discharge source and a plasma generation source. The chamber body has a reaction chamber, wherein the chamber body has a substrate positioning area for positioning the substrate. The monomer discharge source has a discharge inlet for introducing a coating forming material into the reaction chamber of the chamber body. The plasma generation source is disposed in the reaction chamber of the chamber body for exciting the coating forming material, wherein the substrate positioning area is located at a position between the monomer discharge source and the plasma generation source in such manner that the substrate is adapted for being arranged between the monomer discharge source and the plasma generation source.

According to another aspect of the present disclosure, the present disclosure provides a coating apparatus for coating a substrate, wherein the coating apparatus includes a chamber body having a reaction chamber, a supporting rack, a monomer discharge source and a plasma generation source. The supporting rack has a supporting area for supporting the substrate within the reaction chamber of the chamber body. The monomer discharge source has a discharge inlet for introducing a coating forming material into the reaction chamber of the chamber body. The plasma generation source is disposed in the reaction chamber of the chamber body for exciting the coating forming material, wherein the supporting area of the supporting rack is located at a position between the monomer discharge source and the plasma generation source in such manner that the substrate is adapted for being arranged between the monomer discharge source and the plasma generation source.

According to another aspect of the present disclosure, the present disclosure provides a coating method for coating a substrate, wherein the coating method includes the following steps.

(a) Arrange the substrate in a reaction chamber of a chamber body at a position between a monomer discharge source and a plasma generation source.

(b) Introduce a coating forming material into the reaction chamber through the monomer discharge source for forming a polymer coating on a surface of the substrate in the effect of the plasma generation source.

According to another aspect of the present disclosure, the present disclosure provides a coating apparatus for coating a plurality of substrates, wherein the coating apparatus includes a chamber body having a reaction chamber, a monomer discharge source having a discharge inlet for introducing a coating forming material into the reaction chamber of the chamber body, a plasma generation source disposed in the chamber body for exciting the coating forming material, and a supporting rack for supporting the plurality of substrates around the plasma generation source within the chamber body.

Still further objects and advantages will become apparent from a consideration of the ensuing description and drawings.

These and other objectives, features, and advantages of the present disclosure will become apparent from the following detailed description, the accompanying drawings, and the appended claims.

### BRIEF DESCRIPTION OF THE DRAWINGS

FIG. 1A is a schematic view of a conventional coating apparatus.
FIG. 1B is a schematic view of another conventional coating apparatus.
FIG. 2A is a schematic view illustrating a coating apparatus according to a first preferred embodiment of the present disclosure.
FIG. 2B is a schematic view illustrating the coating apparatus being placed with a substrate for implementing the coating method according to the above first preferred embodiment of the present disclosure.
FIG. 2C is a schematic view illustrating the coating apparatus according to an alternative mode of the above first preferred embodiment of the present disclosure.
FIG. 2D is a schematic view illustrating the coating apparatus according to another alternative mode of the above first preferred embodiment of the present disclosure.
FIG. 3A is a schematic view of a coating apparatus according to a second preferred embodiment of the present disclosure.
FIGS. 3B and 3C are schematic views illustrating a supporting rack which is carrying the substrate and moving between a monomer discharge source and a plasma generation source of the coating apparatus according to the above second preferred embodiment of the present disclosure.
FIG. 4A is a schematic view of the coating apparatus according to an alternative mode of above second preferred embodiment of the present disclosure.
FIG. 4B is a schematic view of the coating apparatus according to another alternative mode of above second preferred embodiment of the present disclosure.
FIGS. 5A and 5B are schematic views illustrating a supporting rack which is mounted with the plasma generation source and is carrying the substrate moving between a monomer discharge source and a plasma generation source of the coating apparatus according to another alternative mode of the above second preferred embodiment of the present disclosure.
FIGS. 6A and 6B are schematic views illustrating a supporting rack which is carrying the substrate moving close to or away from a plasma generation source of the coating apparatus according to another alternative mode of the above second preferred embodiment of the present disclosure.
FIG. 7 is a schematic view of a coating apparatus according to a third preferred embodiment of the present disclosure.
FIG. 8 is a schematic view of the coating apparatus according to an alternative mode of the above third preferred embodiment of the present disclosure.
FIG. 9 is a schematic view of the coating apparatus according to another alternative mode of above third preferred embodiment of the present disclosure.
FIG. 10 is a perspective view of a coating apparatus according to a fourth preferred embodiment of the present disclosure.
FIG. 11 is a perspective view of a movable supporting rack with a plasma generation source of the coating apparatus according to the above fourth preferred embodiment of the present disclosure.
FIG. 12 is an exploded view of the movable supporting rack with a plasma generation source of the coating apparatus according to the above fourth preferred embodiment of the present disclosure.
FIG. 13 is an enlarged partial view illustrating the electrical connection between a power source and the plasma generation source of the coating apparatus according to the above fourth preferred embodiment of the present disclosure.
FIG. 14 is a schematic view illustrating the movement of the movable supporting rack of the coating apparatus according to the above fourth preferred embodiment of the present disclosure.
FIG. 15 is a schematic view illustrating the movement of the substrates supported on the movable supporting rack of the coating apparatus according to the above fourth preferred embodiment of the present disclosure.
FIG. 16 is a sectional view along line A-A of FIG. 14.
FIG. 17 is a sectional view along line B-B of FIG. 15.
FIG. 18 is a schematic block diagram illustrating a coating apparatus according to a fifth preferred embodiment of the present disclosure.
FIG. 19 is a structural block diagram illustrating the coating apparatus according to above fifth preferred embodiment of the present disclosure.
FIG. 20 is a structural schematic view illustrating a coating apparatus according to a first modified embodiment of the present disclosure.
FIG. 21 is a structural schematic view illustrating a coating apparatus according to a second modified embodiment of the present disclosure.
FIG. 22 is a structural schematic view illustrating another coating apparatus according to the second modified embodiment of the present disclosure.
FIG. 23 is a structural schematic view illustrating an evolution frame of the coating apparatus according to the second modified embodiment of the present disclosure.

### DETAILED DESCRIPTION

The following description is disclosed to enable any person skilled in the art to make and use the present disclosure. Preferred embodiments are provided in the following description only as examples and modifications will be apparent to those skilled in the art. The general principles defined in the following description would be applied to other embodiments, alternatives, modifications, equivalents, and applications without departing from the spirit and scope of the present disclosure.

It should be appreciated by those skilled in the art that, in the context of the present disclosure, terms "longitudinal", "lateral", "upper", "lower", "front", "back", "left", "right", "vertical", "horizontal", "top", "bottom", "inner", "outer" are based on orientation or positional relationships illustrated in the figures, which are merely for convenience in describing and simplifying the present disclosure, and do not indicate or imply that devices or components must have a particular orientation and be constructed and operated in a particular orientation, thus the above terms should not be construed as limiting the present disclosure.

It should be understood that the term "a" or "an" should be interpreted as "at least one" or "one or more", that is, in some embodiments, the number of one component may be one, and in other embodiments, the number of the component may be multiple, thus the term "a" and "an" should not be construed as limiting the number.

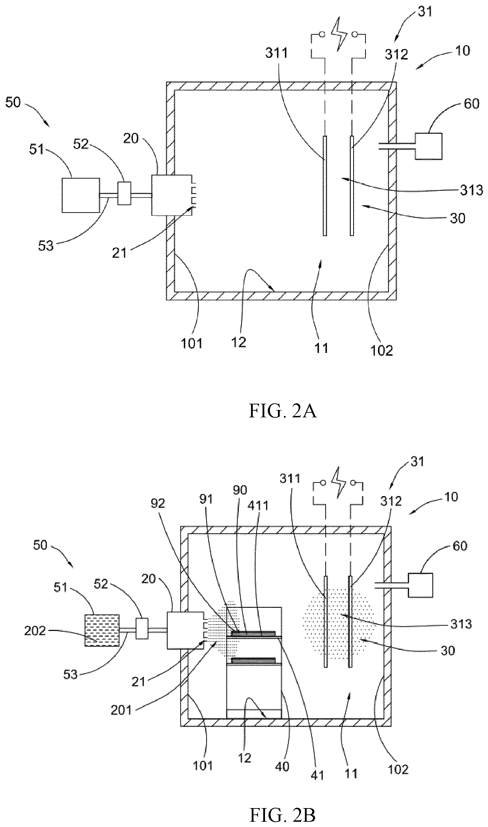

Referring to FIGS. 2A and 2B of the drawings, a coating apparatus which is arranged to implement a novel plasma polymerization coating method for forming a polymer coating 92 on a surface 91 of a substrate 90 according to a first preferred embodiment of the present disclosure is illustrated. More specifically, the coating apparatus includes a chamber body 10 defining a reaction chamber 11, a monomer discharge source 20 communicated to the reaction chamber 11 for introducing a gaseous coating forming material 201, which is a gaseous monomer or monomer vapor, into the reaction chamber 11 of the chamber body 10, and a plasma generation source 30 operable to induce an electrical field internally of the reaction chamber 11 for forming a plasma in such a manner that the plasma generation source 30 applies an electrical power to the coating forming material 201 to excite the coating forming material 201, so as to break down the coating forming material 201 to form reactive precursor species, so that the coating forming material 201 is activated to be in a plasma state, so as to induce reactions between the reactive precursor species and the monomer, as well as reactions between the reactive precursor species themselves in the reaction chamber 11 of the chamber body 10, so that the polymer coating 92 is then deposited and formed on the surface 91 of the substrate 90.

According to this preferred embodiment of the present disclosure, as shown in FIG. 2B of the drawings, the plasma generation source 30 is arranged in the reaction chamber 11 of the chamber body 10 at a position remotely from the monomer discharge source 20, the chamber body 10 has a substrate positioning area 12 which is arranged between the monomer discharge source 20 and the plasma generation source 30, so that at least one substrate 90 is suitable for being arranged in the reaction chamber 11 between the monomer discharge source 20 and the plasma generation source 30 during a plasma polymerization coating method of the present disclosure for forming the polymer coating 92 of the surface 91 of the substrate 90.

Accordingly, during the plasma polymerization coating method of the substrate 90, one or more substrates 90 can be disposed at the substrate positioning area 12 of the chamber body 11 in such a manner that the monomer discharge source 20 is arranged at a first side of the substrate 90 and the plasma generation source 30 is located at an opposite second side of the substrate 90, so that when the coating forming material 201 is discharged into the reaction chamber 11 of the chamber body 10, the coating forming material 201 does not have to pass through the plasma generation source 30 before reaching to the substrate 90, so as to avoid the excessive decomposition of the coating forming material 201.

More specifically, when the monomer discharge source 20 is in operation to discharge the coating forming material 201, the coating forming material 201 disperses into the reaction chamber 11 of the chamber body 10 and reaches the substrate positioning area 12 of the chamber body 10 first, only a proportion of the coating forming material 201 is subject to an exciting process of the plasma generation source 30, rending the coating forming material 201 to decompose, polymerize and deposit on the surface 91 of the substrate to form the polymer coating 92.

In the plasma polymerization coating method of the present disclosure, since the substrate 90 is adapted for being placed in a flowing route of the coating forming material 201 which flows from the monomer discharge source 20 to the plasma generation source 30, and a distance between the substrate 90 and the monomer discharge source 20 is smaller than a distance between the substrate 90 and the plasma generation source 30, not all of the coating forming material 201 is excited by the plasma generation source 30, so that excessive decomposition of the coating forming material 201 is avoided.

The substrate 90 can be directly placed on the substrate positioning area 12 of the chamber body 10. Alternatively, as shown in FIG. 2B of the drawings, a plurality of substrates 90 can be placed on a supporting rack 40, and then the supporting rack 40 which is loaded with the plurality of substrates 90 can be placed on the substrate positioning area 12 of the chamber body 10 and is received in the reaction chamber 11 of the chamber body 10. Alternatively, the supporting rack 40 can be placed on the substrate positioning area 12 of the chamber body 10 and is received in the reaction chamber 11 of the chamber body 10, and then the plurality of substrates 90 can be placed on a supporting rack 40. As another alternative mode, the supporting rack 40 is mounted to the chamber body 10 and is disposed in the reaction chamber 11, during the coating process, the plurality of the substrates 90 is put on the supporting rack 40.

The supporting rack 40 includes a carrier rack 41 which may include multiple supporting platforms for supporting multiple layers of the substrates 90. The carrier rack 41 has a supporting area 411 for placing and supporting the substrate 90, and the supporting area 411 is arranged between the monomer discharge source 20 and the plasma generation source 30. In alternative modes, the whole supporting rack 40 may not be arranged between the monomer discharge source 20 and the plasma generation source 30, but as along as the supporting area 411 of the supporting rack 40 for supporting the substrate 90 is arranged between the monomer discharge source 20 and the plasma generation source 30, the substrate 90 which is adapted for being placed on the supporting area 411 of the supporting rack can be located between the monomer discharge source 20 and the plasma generation source 30.

The person of ordinary skilled in the art should understand that the substrate positioning area 12 of the chamber body 10 is an area for directly supporting one or more substrates 90, or an area for supporting and accommodating the supporting rack 40 which is adapted for being loaded with one or more substrates 90.

The chamber body 10 of the present disclosure is a housing defining the reaction chamber 11. A cross section of the reaction chamber 11 of the chamber body 10 can be, but not limited to, a circular shape, an oval shape, a polygonal shape such as a rectangular shape, a pentagonal shape, a hexagonal shape, a heptagonal shape, an octagonal shape, a nonagonal shape, and a decagonal shape. As an example of this preferred embodiment, the chamber body 10 is configured to have a rectangular reaction chamber 11. The monomer discharge source 20 is arranged at a first side of the rectangular reaction chamber 11 while the plasma generation source 30 can be arranged at an opposite second side of the rectangular reaction chamber 11. As shown in the drawings, the monomer discharge source 20 can be arranged adjacent to a first side wall 101 of the chamber body 10 while the plasma generation source 30 is remotely from the monomer discharge source 20 and is arranged at a second side wall 102 of the chamber body 10 which is opposite to the first side wall 101 of the chamber body 10.

The monomer discharge source 20 has at least one discharge inlet 21 for introducing the coating forming material 201 into the reaction chamber 11 of the chamber body 10. The discharge inlet 21 can be formed in a wall of the chamber body 10 and penetrate a thickness of the wall of the chamber body 10. Alternatively, the discharge inlet 21 can be formed in a feeding nozzle which is embedded in the wall of the chamber body 10. Alternatively, the discharge inlet 21 is formed in a feeding nozzle, which is a feeding head at a distal end of a feeding tube, extending into the reaction chamber 11 of the chamber body 10.

According to this preferred embodiment of the present disclosure, the coating apparatus further includes a monomer supply unit 50 for supplying the coating forming material 201 to the monomer discharge source 20. More specifically, the monomer supply unit 50 of this preferred embodiment includes a material storage member 51 for storing a raw material 202 of the coating forming material 201, a vaporizer52 for vaporizing the raw material 202, and a delivering tube system 53 for delivering the raw material 202 from the material storage member 51 to the monomer discharge source 20. Accordingly, the coating forming material 201 discharged through the monomer discharge source 20 is a gaseous monomer vapor material. The raw material 202 of the coating forming material 201 can be a liquid or liquid/solid slurry, either alone or in mixture, and the vaporizer 52 can include an atomizer, a heating device, an ultrasonic nozzle, or a nebulizer. As an example, the vaporizer 52 may include a heating device which is provided for heating the raw material 202 in the delivering tube system 53 for producing the gaseous monomer vapor material. The heating device may be provided at any position along the delivering tube system 53. Typically, the heating device may be provided at the position corresponding to the monomer discharge source 20, so that when the raw material 202 in a liquid state is delivered to the monomer discharge source 20, the raw material 202 will be heated by the heating device and produce the gaseous monomer vapor material which is discharged into the reaction chamber 11.

The raw material 202 of the coating forming material 201 can be a powder, and the vaporizer 52 can be a plain-jet gas blast atomizer. In addition, a carrier gas may also be supplied along with the coating forming material 201. The number of the material storage member 51, the vaporizer 52, the delivering tube system 53, and the monomer discharge source 20 is not limited, one or more material storage members 51, vaporizers 52, delivering tube systems 53, and monomer discharge sources 20 may be adopted in some embodiments.

An electrical discharge manner of the plasma generation source 30 includes, but not limited to, a direct current discharge, an alternating current discharge, an audio frequency discharge, a radio frequency discharge by a capacitive coupling or an inductive coupling, a microwave discharge by a resonant cavity, a surface wave coupling or an electron cyclotron resonance, a medium frequency discharge, a penning discharge, a spark discharge and a pulse discharge. In addition, the plasma generation source 30 can be operated to discharge electric power continuously, or in a pulsed manner.

As shown in FIG. 2A and 2B of the drawings, the plasma generation source 30 includes an electrode means 31 for generating an electric field in the reaction chamber 11 for establishing the plasma in the reaction chamber 11 of the chamber body 10. According to this preferred embodiment, the electrode means 31 includes a first electrode 311 and a second electrode 312 defining a discharge field 313 between the first and second electrodes 311 and 312. As a typical example, the pair of electrodes 311 and 312 of this preferred embodiment functioning as positive and negative electrodes is disposed in the reaction chamber 11 of the chamber body 10 at a position remotely from the monomer discharge source 20, and is connected to an energy source such as an RF generator which is placed at an outer side of the chamber body 10. Alternatively, the first electrode 311 can be electrically connected to the energy source, and the second electrode 312 can be grounded. Preferably, each of the first and second electrodes 311 and 312 may further be embodied as a porous electrode which has a plurality of holes communicating the discharge field 313 with the reaction chamber 11.

The coating forming material 201 itself can function as a plasma source gas. Furthermore, the coating apparatus may further include a plasma source gas feeding unit for feeding a plasma source gas, which includes, but not limited to, an inert gas and nitrogen, into the reaction chamber 11 of the chamber body 10. Accordingly, before the monomer discharge source 20 feeds the coating forming material 201 into the reaction chamber 11, the plasma source gas can be injected into the reaction chamber 11 to produce the plasma in the effect of the plasma generation source 30, so as to provide a plasma environment for the coating forming material 201. In addition, the carrier gas may function as the plasma source gas, and is introduced into the reaction chamber 11 for generating the plasma before feeding the coating forming material 201 into the reaction chamber 11.

It is appreciated that the person of ordinary skilled in art is able to recognize that one or more additional discharge sources for discharging the coating forming material 201 may be arranged at the chamber body 10 in such a manner that the plasma generation source 30 is at a position between the substrate 90 and the additional discharge sources for discharging the coating forming material 201. In these embodiments, a proportion of the coating forming material 201 is discharged through the monomer discharge source 20 at a position adjacent to the substrate position area 101 of the chamber body while another proportion of the coating forming material 201 is discharged through the additional discharge source and passes through the plasma generation source 30 before reaching to the substrate 90, so that not all of the coating forming material 201 is excited by the plasma generation source 30, so as to prevent all of the coating forming material 201 being decomposed into small species.

In addition, the coating apparatus may further include other components such as a pressure adjustment unit 60 which is adjacent to the plasma generation source 30 and remotely from the monomer discharge source 20 for adjusting a pressure in the reaction chamber 11 of the chamber body 10, a control unit for controlling the operation of the coating apparatus, a tail gas tube for collecting a tail gas. During the plasma polymerization coating method of the present disclosure, the reaction chamber 11 is a vacuum chamber in the effect of the pressure adjustment unit 60 before feeding the coating forming material 201 into the reaction chamber 11. The term "vacuum chamber" means a chamber having a lower gas pressure than what is outside of the chamber, and the term does not necessarily mean that the chamber is exhausted to a vacuum state.

The substrate 90 of the present disclosure includes metal, glass, ceramic, polymer, fabrics, fibers, powder, and semiconductor, and can be, but not limited to an electronic component or electronic device, a mechanical component or mechanical device, a textile or clothing, a glass product, a ceramic product, and etc.. For instance, the electronic component or electronic device can be, but not limited to, a mobile phone, a pager, a radio, a loudspeaker, a microphone, a ringer, a buzzer, a hearing aid, an audio player, a television, a laptop, a notebook, a tablet computer, a keyboard, a PCB circuit board, a display, or a sensor. The polymer coating 92 can be, but not limited to a hydrophobic coating, a hydrophilic coating, an oleophobic coating, an anti-rust coating, a mildew proof coating, a moisture barrier coating, an electrical and thermal conductive coating, a biomedical coating, an optical coating, and a tribological coating. The coated surface 91 of the substrate 90 can be an entire surface of the substrate 90, or a partial area of the entire surface of the substrate 90.

The polymer coating 92 can be formed as an acrylic coating, an epoxy coating, a silicone coating, a polyurethane coating or a paraxylene coating. A typical polymer coating 92 is a hydrophobic polymeric coating while the coating forming material 201 includes -CF3 based perfluoro compounds, per fluorinated alkenes, hydrogen containing unsaturated compounds, optionally substituted alkynes, polyether substituted alkenes, organic compounds including two double bonds, saturated organic compounds having an optionally substituted alky chain of at least 5 carbon atoms optionally interposed with a heteroatom, macrocycles containing at least one heteroatom.

The coating forming material 201 can be a monomer of a single molecule, an oligomer, or a combination thereof. As an example, the oligomer can be a bipolymer such as Parylene C and Parylene N. As an example of the coating forming material 201, the monomer is a mixture of one or more monofunctional unsaturated fluorinated compounds and one or more polyfunctional unsaturated hydrocarbon derivatives. The monofunctional unsaturated fluorinated compounds include, but not limited to 3-(perfluoro-5-methylhexy1)-2-hydroxypropyl methacrylate, 2-(perfluorodecyl)ethyl methacrylate, 2-(perfluorohexyl)ethyl methacrylate, 1,1,2,2-Tetrahydroperfluorotetradecyl acrylate, 1H,1H,2H,2H-Heptadecafluorodecyl acrylate, 1H,1H,2H,2H-Perfluorooctylacrylate, 2-(Perfluorobutyl)ethyl acrylate, (2H-perfluoropropyl)-2-acrylate, (perfluorocyclohexyl)methyl acrylate, 1-propyne,3,3,3-trifluoro-, 1-ethynyl-3,5-difluorobenzene and 4-ethynyl-trifluorotoluene. The polyfunctional unsaturated hydrocarbon derivative includes, but not limited to, ethoxylated trimethylolpropane triacrylate, tripropylene glycol diacrylate, divinylbenzene, poly(ethylene glycol) diacrylate, 1,6-hexanediol diacrylate, ethylene glycol diacrylate, diethylene glycol divinyl ether and neopentyl glycol diacrylate.

As another example, the polymer coating 92 is formed on the surface 91 of the substrate 90 to protect the surface 91 from chemical corrosion and enhance hydrophobic performance. More specifically, the monomer has a structure represented by the following formula: 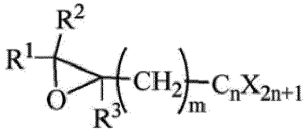 , wherein R1, R2, and R3 are hydrophobic groups and are independently selected from hydrogen, alkyl, halogen, or haloalkyl, wherein m is an integer from 0-8, n is an integer from 1-15, X is selected from hydrogen or halogen, and as an example, X is fluorine.

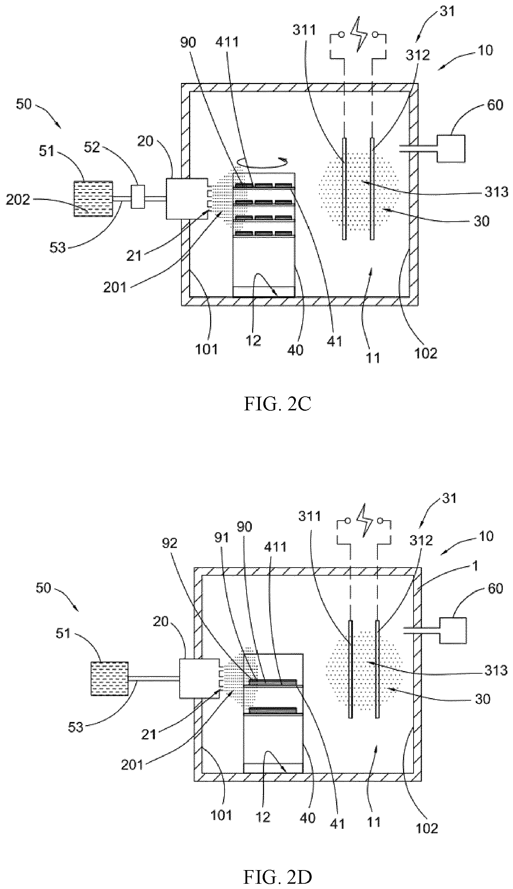

Referring to FIG. 2C of the drawings, an alternative mode of the coating apparatus according to the above first preferred embodiment is illustrated. The supporting rack 40 is movable in the reaction chamber 11 of the chamber body 10. As a specific example, the supporting rack 40 is operable to rotate about a central axis thereof, so that a position of the substrate 90 in the reaction chamber 11 is adjusted, so as to adjust a distance between the substrate 90 and the plasma generation source 30 and to adjust a distance between the substrate 90 and the monomer discharge source 20, so as to control and adjust a composition of a formed polymer material which is deposited on the surface 91 of the substrate 92.

Referring to FIG. 2D of the drawings, another alternative mode of the coating apparatus according to the above first preferred embodiment is illustrated. In this embodiment, the monomer supply unit 50 includes a material storage member 51 for storing a gaseous raw material of the coating forming material 201, and no vaporizer is required. In other words, the coating forming material 201 is stored in the material storage member 51 and is directly fed to the monomer discharge source 20 through the delivering tube system 53.

As an example, the coating apparatus of this preferred embodiment can be used to form a DLC (Diamond-Like Carbon) film on the surface 91 of the substrate 90. The coating forming material 201 mainly consisting of a gaseous hydrocarbon is directly introduced into the reaction chamber 11 to implement the PECVD process.

Accordingly, the present disclosure provides a coating method for coating the substrate 90 by the coating apparatus, and the coating method includes the following steps.
(a) Arrange the substrate 90 in the reaction chamber 11 of the chamber body 10 at a position between the monomer discharge source 20 and the plasma generation source 30.
(b) Introduce the coating forming material 201 into the reaction chamber 11 through the monomer discharge source 20 to implement a PECVD process for forming the polymer coating 92 on the surface 91 of the substrate 90 in the effect of the plasma generation source 30.

The step (a) may include a step of placing one or more substrates 90 at the substrate positioning area 12 of the chamber body, wherein the monomer discharge source 20 and the plasma generation source 30 are respectively provided at two sides of the one or more substrates 90.

Alternatively, the step (a) may include the steps of placing one or more substrates 90 on a supporting rack 40 and placing the supporting rack 40 with the substrates 90 at the substrate positioning area 12 of the chamber body, wherein the monomer discharge source 20 and the plasma generation source 30 are respectively provided at two sides of the supporting rack 40.

Alternatively, the step (a) may include the steps of configuring the supporting rack 40 in the reaction chamber 11 at the substrate positioning area 12 of the chamber body 10 and loading one or more substrates 90 on the supporting rack 40, wherein the supporting rack 40 can be mounted and secured in the chamber body 10, or is just placed in the reaction chamber 11.

It is worth mentioning that the one or more substrates 90 can be horizontally, inclinedly, or vertically placed in the reaction chamber 11 of the chamber body 10.

In the step (a), the coating method includes a step of spacedly arranging the monomer discharge source 20 and the plasma generation source 30 in the reaction chamber 11 at two opposite sides of the reaction chamber 11 of the chamber 10 and positioning one or more substrates 90 in a flowing path of the coating forming material 201 from the monomer discharge source 20 to the plasma generation source 30 in such a manner that at least a portion of the coating forming material 201 has to pass through the substrate positioning area 12 which is placed with the substrates 90 before reaching to the plasma generation source 30.

The step (b) may include steps of vaporizing the raw material 202 to form the coating forming material 201 which is a monomer vapor and delivering the coating forming material 201 to the monomer discharge source 20 for feeding the coating forming material 201 into the reaction chamber 11 of the chamber body 10. Accordingly, the coating forming material 201 can be pumped into the reaction chamber 11, or drawn into the reaction chamber 11 as a result of a reduction of pressure in the reaction chamber 11.

The step (b) may include a step of supplying the coating forming material 201 which is a gaseous monomer to the monomer discharge source 20 for feeding the coating forming material 201 into the reaction chamber 11 of the chamber body 10.

According to this preferred embodiment, in the step (b), as shown in FIG. 2B of the drawings, the coating forming material 201 is dispersed through the monomer discharge source 20 into the chamber body 11 towards the plasma generation source 30. For example, the coating forming material 201 is horizontally injected into the chamber body 11 towards the plasma generation source 30, but the supporting rack 40 is arranged between the monomer discharge source 20 and the plasma generation source 30, the coating forming material 201 is not required to pass through the plasma generation source 30 before reaching to the substrate 90 for plasma processing the substrate 90, so that not all of the coating forming material 201 is activated and excited by the plasma generation source 30.

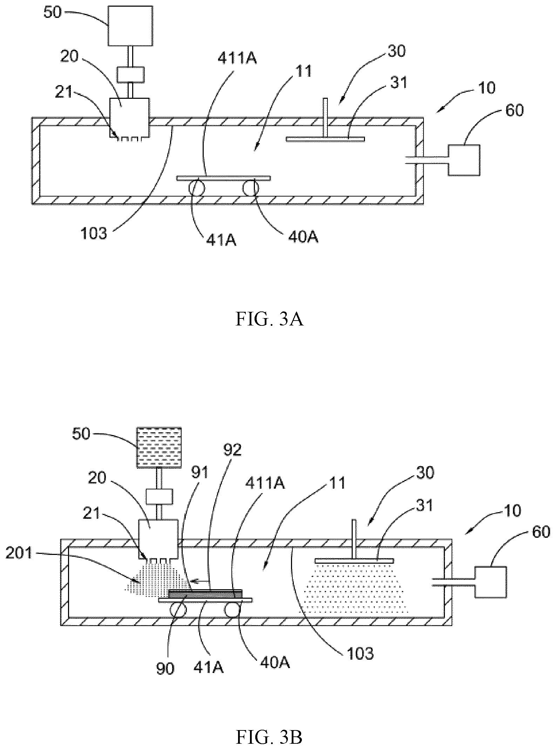

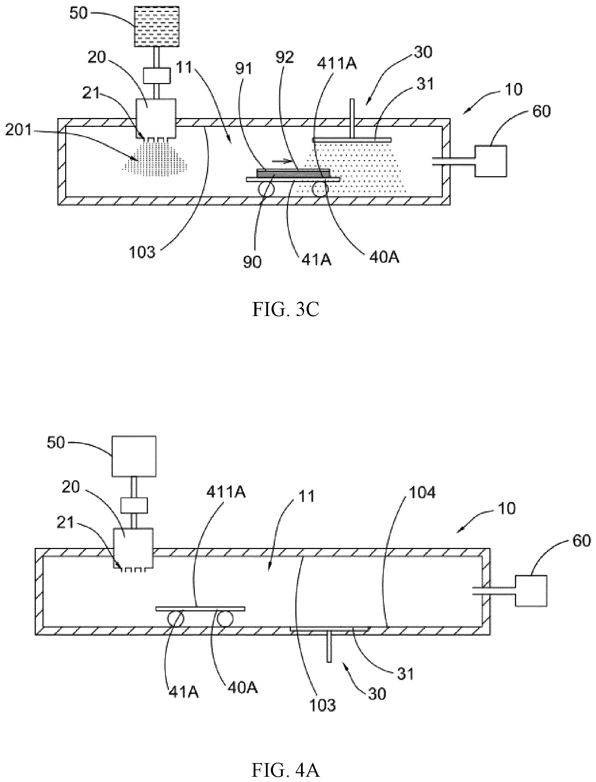

Referring to FIG. 3A to FIG. 3C of the drawings, a coating apparatus according to a second preferred embodiment of the present disclosure is illustrated. The coating apparatus of this preferred embodiment includes a chamber body 10 having a reaction chamber 11, a monomer discharge source 20 for discharging a gaseous coating forming material 201 into the reaction chamber 11 of the chamber body 10, a plasma generation source 30 remotely from the monomer discharge source 20 operable to activate and excite the coating forming material 201, and a supporting rack 40A for supporting and carrying a substrate 90 on a supporting area 411A, so that when the plasma generation source 30 is in operation and a coating forming material 201 is fed into the reaction chamber 11, the substrate 90 is exposed to a plasma generated by the plasma generation source 30 to allow a polymer coating 92 to be deposited and formed on a surface 91 of the substrate 90.

According to this preferred embodiment, the supporting rack 40A is embodied as a movable supporter that is movable in the reaction chamber 11 of the chamber body 10. Particularly, the supporting rack 40A is movable between the monomer discharge source 20 and the plasma generation source 30. A movement manner of the supporting rack 40 can be, but not limited to, a linear movement, a curvilinear movement, a sliding movement or a rotating movement, so that a position of the substrate 90 in the reaction chamber 11 is adjusted, so as to adjust the amount of the monomer and the decomposed precursors which are deposited on the substrate 90 so as to increase a quality of the formed polymer coating 92 on the surface 91 of the substrate 90. In some embodiments, the movement of the supporting rack 40A provides a substantial same plasma polymerization environment for a plurality of the substrates 90, so as to enhance a uniformity of the formed polymer coatings 92 on the substrates 90.

The movement of the supporting rack 40A may be configured for producing a relative displacement between the substrate 90 and the monomer discharge source 20, or producing a relative displacement between the substrate 90 and the plasma generation source 30, or for producing both of the above mentioned relative displacements, so that an amount of the monomer which is not excited by the plasma generation source 30, or an amount of the reactive precursor species produced by breaking down the monomer, reaching to the substrate 90 can be adjusted, so as to ensure suitable and adequate reactions of the monomer and the reactive precursor species.

It is worth mentioning that the movement of the supporting rack 40A can be controlled by a control unit which is programmed to adjust a moving manner, a moving time interval, or a moving speed of the supporting rack 40A, so as to provide a desired plasma polymerization environment for the substrate 90 to obtain desired branching and cross-linking in a molecular structure of the polymer coating 92 and form the polymer coating 92 with a relatively high quality.

According to this preferred embodiment, as shown in FIG. 3A to 3C of the drawings, the supporting rack 40A is embodied as a movable supporter that is capable of repeatedly moving between the monomer discharge source 20 and the plasma generation source 30, so as to adjust the distance between the substrate 90 and the monomer discharge source 20, as well as the distance between the substrate 90 and the plasma generation source 30.

As a specific example, the chamber body 10 has a rectangular reaction chamber 11, the monomer discharge source 20 and the plasma generation source 30 can be arranged at a same side wall of the chamber body 10 and are spacedly apart from each other. For example, the monomer discharge source 20 and the plasma generation source 30 are arranged at a top side wall 103 of the chamber body 10. During the plasma polymerization coating method, the monomer discharge source 20 discharges the coating forming material 201, and a monomer area is defined in front of the monomer discharge source 20, the plasma generation source 30 is in operation for creating a plasma generation area around it, the supporting rack 40A is moving back and forth between the monomer area and the plasma area.

As shown in the drawings, in this preferred embodiment, the coating forming material 201 is not dispersed into the reaction chamber 11 through the monomer discharge source 20 towards the plasma generation source 30, but can be transversely introduced into the reaction chamber 11, and then is longitudinally dispersing towards the substrate 90 and the plasma generation source 30, so that the gaseous flow of the coating forming material 201 discharged through the monomer discharge source 20 will not directly blow the plasma generated around the plasma generation source 30, rendering a desired mixing performance of the monomer and the reactive precursor species which are broken down from the monomer.

The person of ordinary skilled in the art will understand that the supporting rack 40A, which is operable to move between the monomer discharge source 20 and the plasma generation source 30, can be driven by an electric motor, a pneumatically driving system, or a hydraulic driving system. The chamber body 10 can be provided with guiding rails or guiding grooves for retaining the supporting rack 40A in position, as well as for guiding and restricting the movement of the supporting rack 40A.

As shown in the drawings, the electrode means 31 of the plasma generation source 30 of this preferred embodiment is desired to be constructed to be a planar electrode which is extending in the reaction chamber 11, other electrode means for creating the electric field also can be adopted.

Accordingly, this preferred embodiment of the present disclosure provides a coating method for depositing the polymer coating 92 on the surface 91 of the substrate 90, and the coating method includes the following steps.
(A) Feed the coating forming material 201 into the reaction chamber 11 of the chamber body 10 through the monomer discharge source 20 which is remotely from the plasma generation source 30.
(B) Move the substrate 90 between the monomer discharge source 20 and the plasma generation source 30.
(C) Activate the plasma generation source 30 to plasma process the substrate 90 for forming the polymer coating 92 on the surface 91 of the substrate 90.

It should be noted that the step sequence of the above steps (A), (B) and (C) is not limited. In the step (B), the step may include the steps of carrying the substrate 90 on a supporting rack 40A and driving the supporting rack 40A to repeatedly move back and forth between the monomer discharge source 20 and the plasma generation source 30. More specifically, as a preferred example, the supporting rack 40A is driven to move to adjust the distance between the substrate 90 and the monomer discharge source 20, as well as the distance between the substrate 90 and the plasma generation source 30.

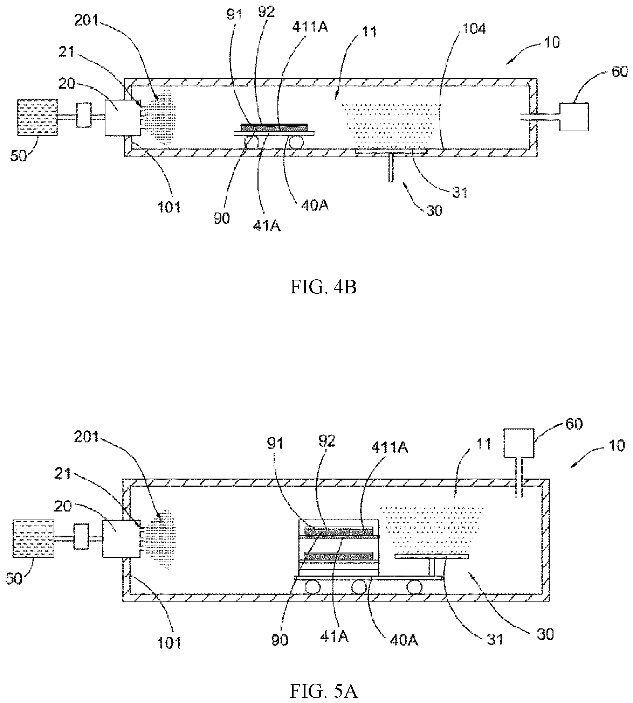

Referring to FIG. 4A of the drawings, as an alternative mode, the monomer discharge source 20 and the plasma generation source 30 may be arranged adjacent to two opposite side walls of the chamber body 10. For example, the monomer discharge source 20 is arranged adjacent to a top side wall 103 while the plasma generation source 30 is mounted to a bottom side wall 104 of the chamber body 10. As shown in FIG. 4B of the drawings, as another alternative mode, the monomer discharge source 20 may be arranged adjacent to at an end side wall 101 of the chamber body 10 for discharging the coating forming material 201 towards the substrate 90 while the plasma generation source 30 may be arranged at a bottom wall 104 of the chamber body 10. In other words, the monomer discharge source 20 and the plasma generation source 30 can be arranged at adjacent side walls 101 and 104 of the chamber body 10.

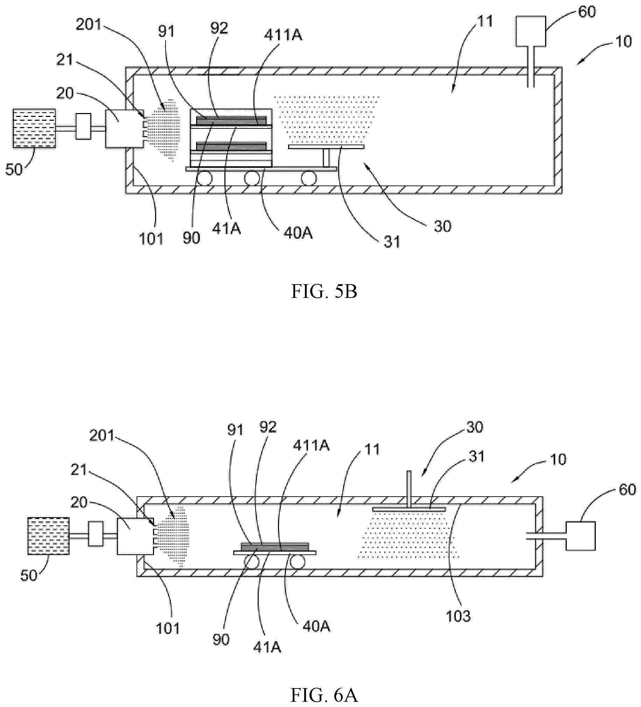

Referring to FIG. 5A and FIG. 5B of the drawings, as still another alternative mode of the above preferred embodiment, the plasma generation source 30 can be mounted to the supporting rack 40A at a side which is opposite to the monomer discharge source 20. The supporting rack 40A is immovable, or preferably, the supporting rack 40A is configured to be movable to adjust the distance between the supporting rack 40A and the monomer discharge source 20, and the distance between the monomer discharge source 20 and the plasma generation source 30 is also adjusted. According to this preferred embodiment, the relative position between the substrate 90 and the plasma generation source 30 can be fixed, but the plasma generation source 30 can move along with the supporting rack 40A to change the plasma creating environment within the reaction chamber 11 of the chamber body 10.

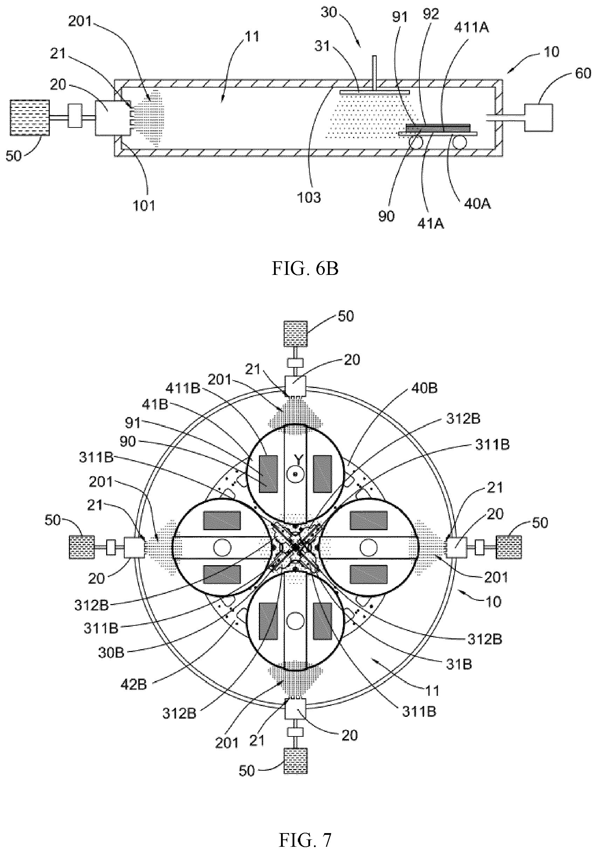

Referring to FIG. 6A and FIG. 6B of the drawings, another alternative mode of the coating apparatus is illustrated. In this embodiment, the person of ordinary skilled in the art should understand that the supporting rack 40A may also move to a position in such a manner that the plasma generation source 30 is located between the monomer discharge source 20 and the substrate 90. However, during the movement of the supporting rack 40A between the monomer discharge source 10 and the plasma generation source 30, the coating forming material 201 has to pass through the supporting rack 40A before reaching to the plasma generation source 30, so that not all of the coating forming material 201 is required to pass through the plasma generation source 30 before reaching to the substrate 90.

In other words, this preferred embodiment provides a coating method for depositing the polymer coating 92 on the surface 91 of the substrate 90 including the followings steps.

Move the substrate 90 in the reaction chamber 11 of the chamber body 10 defining a moving path of the substrate 90, wherein during at least a proportion of the moving path, the substrate 90 is located at a position between the monomer discharge source 20 and the plasma generation source 30.

Discharge the coating forming material 201 into the reaction chamber of the chamber body 10 to activate the plasma process of the substrate 90 during the operation of the plasma generation source 30.

Accordingly, the moving path of the substrate 90 can be divided a first proportion in which the monomer discharge source 20 and the plasma generation source 30 are respectively located at two sides of the substrate 90 and a second proportion in which the monomer discharge source 20 and the substrate 90 are respectively located at two sides of the plasma generation source, and the first portion of the moving path can be significantly larger than the second portion of the moving path of the substrate 90 which is carried by the supporting rack 40A.

Referring to FIG. 7 of drawings, a coating apparatus according to a third preferred embodiment of the present disclosure is illustrated. More specifically, the coating apparatus of this preferred embodiment includes a chamber body 10 having a reaction chamber 11, one or more monomer discharge sources 20 for discharging a gaseous coating forming material 201 into the reaction chamber 11 of the chamber body 10, a plasma generation source 30B for exciting the coating forming material 201, and a supporting rack 40B for supporting and carrying a substrate 90, so that when the plasma generation source 30B is in operation and a coating forming material 201 is fed into the reaction chamber 11 through the one or more monomer discharge sources 20, a polymer coating 92 is deposited and formed on a surface 91 of the substrate 90.

According to this preferred embodiment, the plasma generation source 30B is arranged at a substantial central area of the supporting rack 40B. In this embodiment, the plasma generation source 30B may not be mounted to the supporting rack 40B, and is mounted to the chamber body 10 and supported in the reaction chamber 11. Preferably, the plasma generation source 30B can be arranged at the center of the reaction chamber 11 of the chamber body 10 while a plurality of substrates 90 which is to be coated with the polymer coating 92 is adapted for being arranged around the plasma generation source 30B to encircle the plasma generation source 30B, so that the substrate 90 is adapted for being arranged between the plasma generation source 30B and the monomer discharge source 20.

Accordingly, the plasma generation source 30B is arranged at the center of the reaction chamber 11 of the chamber body 10, so as to provide a relatively even electrical exciting environment in the reaction chamber 11 of the chamber body 10. More specifically, when the coating forming material 201 is discharged into the reaction chamber 11, the coating forming material 201 which is the monomer is excited by the plasma generation source 30B to produce reactive precursor species that are relatively evenly dispersed around the plasma generation source 30B.

Accordingly, as shown in the drawings, the plasma generation source 30B is provided at a central area 111 of the reaction chamber 11 of the chamber body 10 for exciting the coating forming material 201 dispersed into the reaction chamber 11, the uniformity of a concertation of reactive precursor species around the plasma generation source 30B is increased, so as to increase a quality of the formed polymer coating 92 on the surface 91 of the substrate 90.

More specifically, a plurality of monomer discharge sources 20, such as four monomer discharge sources 20, can be arranged at positions adjacent to an inner wall of the chamber body 10, and coating forming material 201 can be discharged at positions adjacent to an inner perimeter of the chamber body 10 and flow towards the plasma generation source 30B at the central position of the chamber body 10. Since the plurality of monomer discharge sources 20 and the plasma generation source 30B are provided at two opposite sides of the substrate 90, excessive decomposition of the coating forming material 201 is prevented.

The plasma generation source 30B of this preferred embodiment of the present disclosure includes an electrode means 31B for applying an electric power to the coating forming material 201 discharged into the chamber body 10. More specifically, as an example, the electrode means 31B includes at least one pair of electrodes, preferably, a plurality of pairs of first electrode 311B and second electrode 312B are provided at the center of the reaction chamber 11. As shown in FIG. 7 of the drawings, each of the first electrodes 311B and second electrodes 312B can be embodied as an elongated electrode plate vertically arranged in the reaction chamber 11 of the chamber body 10. In this exemplifying embodiment, four first electrodes 311B and four second electrodes 312B are alternatingly arranged along a circumferential direction.

The first electrodes 311B and the second electrodes 311B are positive and negative electrodes, and are respectively electrically connected to two connecting ends of an energy source such as an RF generator which is placed at an outer side of the chamber body 10. Alternatively, the first electrode 311B can be electrically connected to the energy source, and the second electrode 312B can be grounded.

The supporting rack 40B of this preferred embodiment includes one or more carrier racks 41B for carrying one or more substrates 90. Each of the carrier racks 41B has a supporting area 411B for positing the substrate 90 which can be horizontally, inclinedly, and vertically placed at the carrier set 411B. In this embodiment, the substrate 90 can be horizontally placed at the supporting area 411B and is retained and supported by the supporting area 411B.

According to this preferred embodiment, a plurality of supporting areas 411B of one or more carrier rack 41B is arranged between the plasma generation source 30B and the monomer discharge source 20, so that when one or more substrates 90 are placed at the corresponding supporting area 411B, the monomer discharge source 20 and the plasma generation source 30B are respectively arranged at two opposite sides of each corresponding substrate 90.

Furthermore, each of the carrier racks 41B of the supporting rack 40B of this preferred embodiment can carry a plurality of the substrates 90 and is movable in the reaction chamber 11, and the movement of each of the carrier racks 41B can be, but not limited to, a linear movement, a curvilinear movement, a sliding movement, and a rotation movement. As a specific example of this preferred embodiment, each of the carrier racks 41B of the supporting rack 40B is operable to rotate about a central axis Y thereof.

The supporting rack 40B of this preferred embodiment further includes a movable rack 42B for supporting the one or more carrier racks 41B. The movement of the movable rack 42B also can be, but not limited to, a linear movement, a curvilinear movement, a sliding movement, and a rotation movement.

According to this preferred embodiment, the movable rack 42B is functioning as a rotation rack that is operable to rotate about a central axis X within the reaction chamber which is embodied as a circular chamber, and since the carrier racks 41B are supported on the movable rack 42B, each of the carrier racks moves along with the movable rack 42B while simultaneously self-rotate with respect to its central axis Y, so that two types of the movements of the carrier racks 41B change the relative position between each of the substrates 90 and the plasma generation source 30.

The movement of the movable rack 42B and the movement of the carrier racks 41B also function to stir the coating forming material 201 in the reaction chamber 11, so as to evenly mix the monomer and the reactive precursor species around the plasma generation source 30B, so as to increase the quality of the polymer coating 92 on the surface 91 of the substrate 90.

Accordingly, the present disclosure further provides a coating method for coating a plurality of substrates 90, including the following steps.
(I) Arrange the plasma generation source 30B at a central area 111 of the reaction chamber 11 of the chamber body 11.
(II) Place the plurality of substrates 90 around the plasma generation source 30B.
(III) Discharge the coating forming material 201 into the reaction chamber 11 of the chamber body 10 through the monomer discharge source 20 and activate the plasma generation source 30D to plasma processing the plurality of substrates 90.

Accordingly, in the Step (II), the method may further include a step of moving the plurality of substrates 90 around the plasma generation source 30B, the step (III) may include a step of radially discharging the coating forming material 201 through a plurality of monomer discharge sources 20 towards said plasma generation source 30B at a central of the reaction chamber 11 of the chamber body 10.

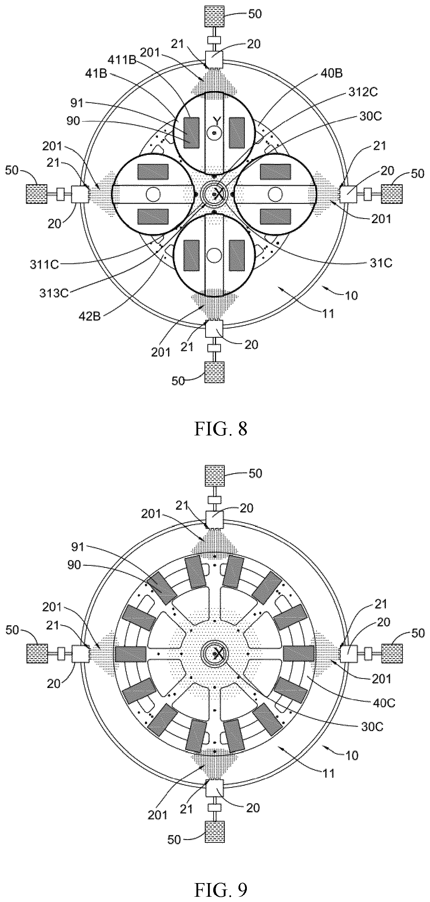

Referring to FIG. 8 of the drawings, as an alternative mode of the above third preferred embodiment of the present disclosure, the coating apparatus include a plasma generation source 30C which includes an electrode means 31C. The electrode means 31C of this preferred embodiment includes a first electrode 311C and a second electrode 312C each of which is embodied as a cylindrical electrode, the first electrode 311C is sleeved around the second electrode 312C to define a circular discharge field 313C between the first electrode 311C and the second electrode 312C. The first electrode 311C can be electrically connected to an energy source such as an RF generator, and the second electrode 312C can be grounded. The plasma generation source 30C is provided at a central area 111 of the reaction chamber 11 of the chamber body 10 for providing a relatively even electrical discharging environment for the coating forming material 201 fed into the reaction chamber 11.

In addition, the first electrode 311C can be embodied as a porous electrode having a plurality of holes that communicate the discharge field 313C to the reaction chamber 11, the second electrode 312C is formed as an elongated tube having communicating holes which are communicated with the reaction chamber 11, so that it may further function as a gas extracting tube communicated to an outer side of the reaction chamber 11 of the chamber body 10 for extracting the gaseous mixture out of the reaction chamber 11 of the chamber body 10, so as to adjust the pressure within the reaction chamber 11 as well as to remove the tail gas in the reaction chamber 11.

Referring to FIG. 9 of the drawings, according to another alternative mode of the above preferred embodiment of the present disclosure, the coating apparatus includes the plasma generation source 30C and a supporting rack 40C. In this preferred embodiment, the supporting rack 40C functions as a rotation rack that is capable of rotating about its central axis X, and a plurality of substrates 90 can be directly put on the supporting rack 40C without requiring the carrier racks 41B mentioned above. The displacement of the plurality of substrates 90 is resulting from the rotation of the supporting rack 40C. The plasma generation source 30C is provided at a central area 111 of the reaction chamber 11 of the chamber body 10 for providing a relatively even electrical discharging environment for the coating forming material 201 fed into the reaction chamber 11.

According to this preferred embodiment of the present disclosure, a coating method for depositing the polymer coating 92 on the surface 91 of each of the plurality of substrates 90 includes the following steps.

(α) Surround the plasma generation source 30B/30C by the plurality of substrates 90 and configure the monomer discharge source 20 and the plasma generation source 30B/30C at two opposite sides of the substrates 90.

(β) Discharge the coating forming material 201 into the reaction chamber 11 of the chamber body 10 to plasma processing the substrates 90 by the plasma generation source 30B/30C.

Accordingly, in the step (α), the plasma generation source 30B/30C is arranged at an inner side of the substrates 90 while the monomer discharge source 20 is arranged at an outer side of the substrates 90. The plasma generation source 30B/30C can be arranged at a central area of the reaction chamber 11 and the substrates 90 are encircled around the plasma generation source 30B/30C.

In the step (β), at least a proportion of the coating forming material 201 is required to pass through the supporting rack 40B/40C which is carried with the substrates 90 before reaching to the plasma generation source 30B/30C.

The step (β) may further include a step of circumferentially arranging a plurality of the monomer discharge sources 20 and radially discharging the coating forming material 201 through the monomer discharge sources 20 towards the plasma generation source 30B/30C at the central area of the reaction chamber 11 of the chamber body 10.

The coating method may further include the steps of rotating a rotation rack 42B about the central axis X and rotating the carrier racks 41B about the central axis Y, wherein each of the carrier racks 41B, which is used for carrying the substrates 90, is supported on the rotation rack 42B to rotate about the axis X along with the rotation rack 42B while simultaneously rotate about its own axis Y.

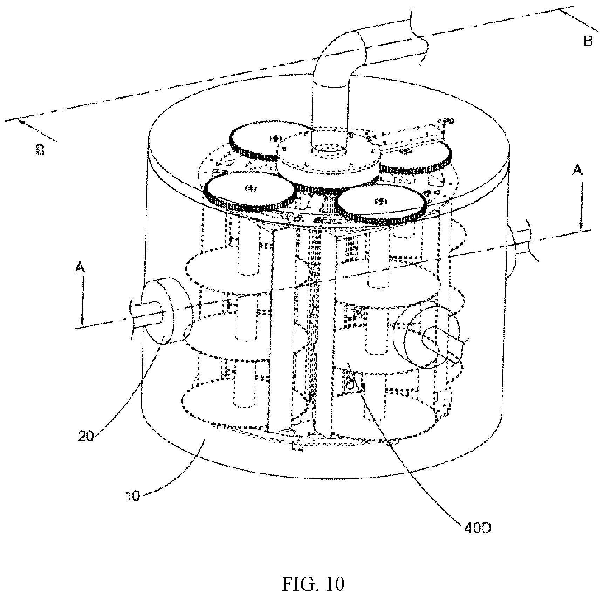

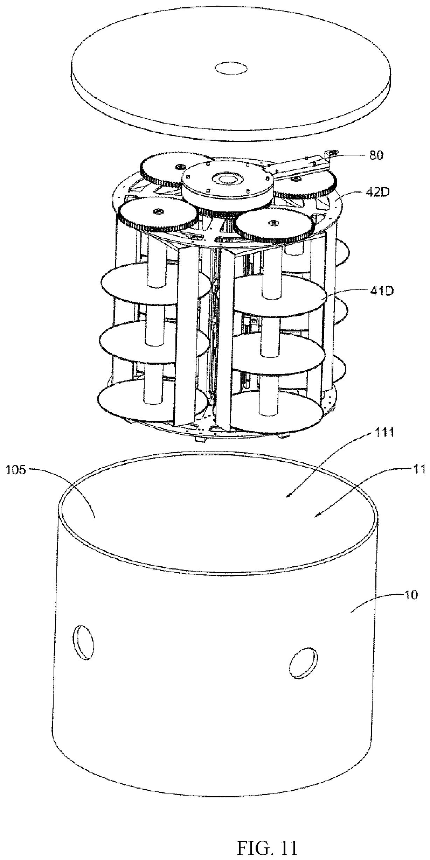

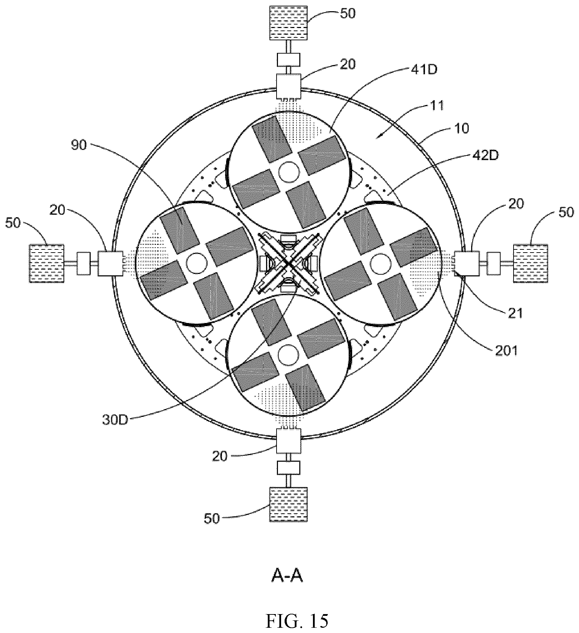

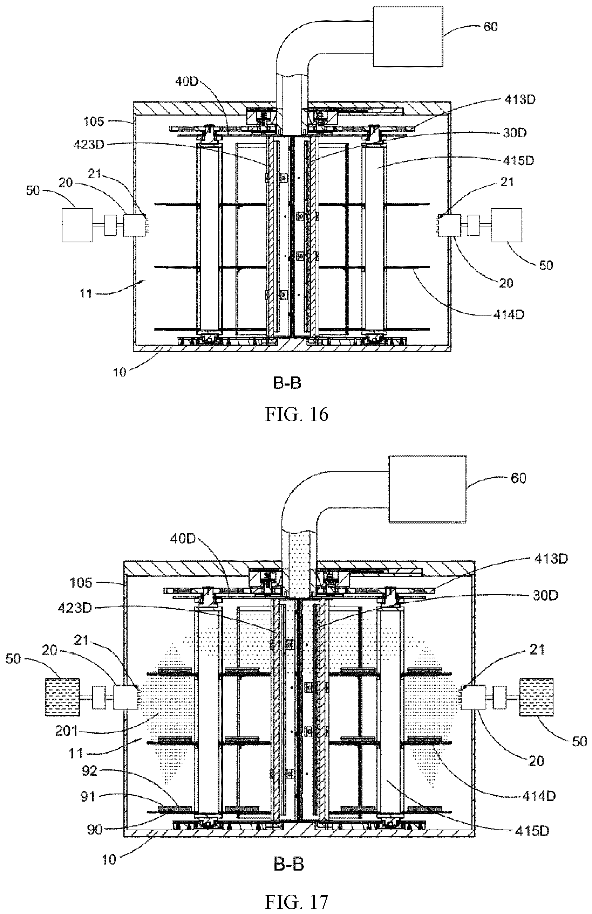

Referring to FIG. 10 to 17 of the drawings, a coating apparatus according to a third preferred embodiment of the present disclosure is illustrated. More specifically, the coating apparatus of this preferred embodiment includes a chamber body 10 having a reaction chamber 11, a discharge source 20 having a discharge inlet 21 for discharging a gaseous coating forming material 201 into the reaction chamber 11 of the chamber body 10, a plasma generation source 30D for exciting the coating forming material 201, so that when the plasma generation source 30D is in operation and a coating forming material 201 is fed into the reaction chamber 11 through the monomer discharge source 20, a polymer coating 92 is deposited and formed on a surface 91 of the substrate 90.

According to this preferred embodiment, the plasma generation source 30D is arranged at a central area 111 of the reaction chamber 11 of the chamber body 10. A plurality of substrates 90 can be adapted for being arranged around the plasma generation source 30D and being positioned between the plasma generation source 30D and the monomer discharge source 20. The plasma generation source 30D which is preferred to be arranged at the center of the reaction chamber 11 is able to provide an electrically discharging field at the center area 11 of the reaction chamber 11, so that the coating forming material 201 dispersed into the reaction chamber 11 is able to be excited by the plasma generation source 30D and evenly and radially disperse from the area corresponding to the plasma generation source 30D to the space around the plasma generation source 30D within the reaction chamber 11, so that the excited coating forming material is able to relatively evenly reach to the substrates 90 around the plasma generation source 30D, so that the substrates 90 are able to be formed with the polymer coating 92 of relatively increased uniformity.

The plurality of substrates 90 can be directly placed on a substrate positioning area of the chamber body 10. Preferably, as shown in the drawings, the coating apparatus further includes a supporting rack 40D for supporting and carrying the plurality of substrates 90. The supporting rack 40D can be fixed or detachably mounted to the chamber body 10 and is disposed in the reaction chamber 11, during the coating process, the plurality of substrates 90 is put on the supporting rack 40D.

According to this preferred embodiment, the plasma generation source 30D is mounted at the supporting rack 40D. Preferably, the plasma generation source 30D can be arranged at the center of the supporting rack 40D while the plurality of substrates 90 is adapted for being arranged around the plasma generation source 30B, so that the plurality of substrates 90 is adapted for being arranged between the plasma generation source 30D and the monomer discharge source 20.

Preferably, the supporting rack 40D of this embodiment is operable to move in the reaction chamber 11 of the chamber body 10. Since the plasma generation source 30D is mounted at the supporting rack 40D, the plasma generation source 30D will move along with the supporting rack 40D when the supporting rack 40D is actuated to move. Particularly, the supporting rack 40D is operable to rotate within the reaction chamber 11, and the plasma generation source 30D is also driven to rotate along with the supporting rack 40D, so that a relatively even electrical discharging environment is provided to the coating forming material 201 introduced into the reaction chamber 11 of the chamber body 10. The rotating supporting rack 40D also can function to stir the coating forming material 201 supplied into the reaction chamber, so as to evenly mix the monomer and the reactive precursor species generated from the excited coating forming material, so as to obtain adequate reactions between the reactive precursor species and reactions between the monomer and the reactive precursor species.

More specifically, the supporting rack 40D includes one or more carrier racks 41D, such as four carrier racks 41D, and a movable rack 42D for supporting the carrier racks 41D. The plasma generation source 30D is mounted at the movable rack 42D of the supporting rack 40D. When the movable rack 42D is operable to rotate in the reaction chamber 11, the carrier racks 41D and the plasma generation source 30D will be driven to rotate along with the movable rack 42D.

According to this preferred embodiment, the plasma generation source 30D can rotate along with the movable rack 42D, the relative movement of the plasma generation source 30D and the movable rack 42D can be avoided, so that the movement of the movable rack 42D will not provide a shielding effect to the plasma generation source 30D.

More specifically, as shown in FIGS. 10 to 12 of the drawings, the movable rack 42D includes a top frame 421D, a lower frame 422D and a plurality of connectors 423D extended between the top frame 421D and the lower frame 422D. The carrier racks 41D are supported by the top frame 421D and the lower frame 422D of the movable rack 42D. As shown in the drawings, four carrier racks 41D are positioned above the lower frame 422D along a circumferential direction of the movable rack 42D. Furthermore, each of the carrier racks 41D of the supporting rack 40D of this preferred embodiment can carry a plurality of the substrates 90 and is movable in the reaction chamber 11, and the movement of each of the carrier racks 41D can be, but not limited to, a linear movement, a curvilinear movement, a sliding movement, and a rotation movement. As a specific example of this preferred embodiment, each of the carrier racks 41D of the supporting rack 40D is operable to rotate about a central axis Y thereof.

More specifically, according to this preferred embodiment, the movable rack 42D is functioning as a rotation rack that is operable to rotate about a central axis X within the reaction chamber 11 which is embodied as a circular chamber, and since the carrier racks 41D are supported on the movable rack 42D, each of the carrier racks moves along with the movable rack 42D while simultaneously self-rotate with respect to its central axis Y, so that two types of the movements of the carrier racks 41D change the relative position between each of the substrates 90 and the plasma generation source 30D, the disclosure of US20190085447A1 is incorporated herewith by references in its entities.

During the plasma coating method, since the plurality of substrates 90 is supported on the carrier racks 41D, each of the carrier racks 41D is operable to rotate with its central axis Y, the plurality of substrates 90 is able to move with respect to the plasma generation source 30D which is arranged at the central area 11 of the reaction chamber 11, so that one or more substrates 90 which are supported on one of the carrier racks 41D are repeatedly and alternatingly moving close to the plasma generation source 30D, so as to provide an relatively even plasma processing field to the plurality of substrates 90, and thus the quality of the polymer coatings 92 on the surfaces of the plurality of substrates 90 is enhanced.

As shown in the drawings, four monomer discharge sources 20 are arranged at positions adjacent to an inner wall 105 of the chamber body 10, and the coating forming material 201 can be discharged at positions adjacent to an inner perimeter of the chamber body 10 and flow towards the plasma generation source 30D at the central area 111 of the chamber body 10. Accordingly, the coating forming material 201 can be evenly and radially introduced into the reaction chamber 11 and disperse towards the center of the reaction chamber 11, the plasma generation source 30D at the central area 111 of the reaction chamber 11 generates an electrical discharging field for the coating forming material 201 to excite the coating forming material 201, a relatively even mixture of the monomer and the reactive precursor species is provided in the reaction chamber 11, so as to increase the uniformity of the polymer coatings 92 formed on the surfaces 91 of the substrates 90.

In addition, since the plurality of monomer discharge sources 20 and the plasma generation source 30D are provided at two opposite sides of the substrate 90 to configure the plurality of substrates 90 at positions between the monomer discharge sources 20 and the plasma generation source 30D, so that excessive decomposition of the coating forming material 201 is prevented.

Each of the carrier racks 41D includes a carrier frame 412D, a rotation gear 413D, one or more supporting seats 414D for supporting the plurality of substrates 90, and a rotation shaft 415D which is operable to rotate so as to drive the carrier rack 41D to rotate. More specifically, the carrier frame 412D includes a supporting arm 4121D and two retention arms 4122D extended from two ends of the supporting arm 4121D respectively. The rotation gear 413D is mounted and supported on the supporting arm 4121D, the supporting seats 414D are connected to the two retention arms 4122D.

As shown in the drawings, the rotation gear 413D is supported on the top frame 421D. The movable rack 42D further includes a retention gear 424D mounted on top of the top frame 421D. The plurality of rotation gears 413D is provided around the retention gear 424D. More specifically, each of the rotation gears 413D is engaged with the retention gear 424D and can be driven by the rotation shaft 415D to rotate with respect to the retention gear 424D.

Accordingly, each of the carrier racks 41D is able to rotate along with the movable rack 42D when the movable rack 42D is actuated to rotate with respect its central axis X, while being driven to rotate with respect to its central axis Y, the retention gear 424D at the center of movable rack 42D guides the rotation of each of the rotation gears 413D. The plurality of substrates 90 which is supported on the corresponding supporting seats 414D will rotate along with the movable rack 42D as well as rotate with respect the plasma generation source 30D.

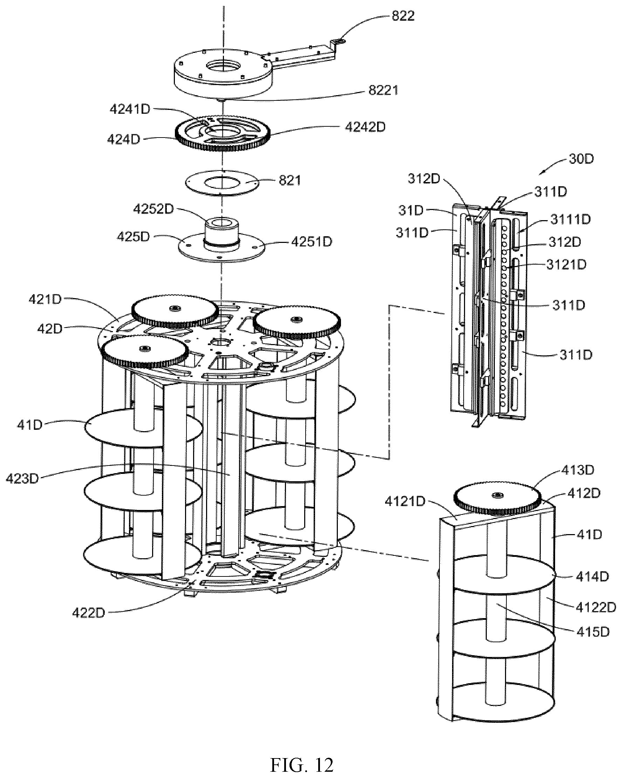

The plasma generation source 30D of this preferred embodiment of the present disclosure includes an electrode means 31D for applying an electric power to the coating forming material 201 discharged into the chamber body 10. More specifically, as an example, the electrode means 31D includes at least one pair of electrodes, preferably, a plurality of pairs of first electrode 311D and second electrode 312D are provided at the center of the reaction chamber 11. As shown in FIG. 12 of the drawings, each of the first electrodes 311D and second electrodes 312D can be embodied as an elongated electrode plate vertically arranged in the reaction chamber 11 of the chamber body 10. In this exemplifying embodiment, a plurality of first electrodes 311D and second electrodes 312D can be alternatingly arranged along a circumferential direction. Alternatively, a pair of electrodes is provided in such a manner that each of the first and second electrodes 311D and 312D is an electrode sleeve. Alternatively, a pair of electrodes is provided in such a manner that the first and second electrodes 311D and 312D are parallel electrode plates. Each of the first electrodes 311D may have a plurality of first communicating holes 3111D, while each of the second electrodes 312D may have a plurality of second communicating holes 3121D, the communicating holes 3111D and 3121D facilitate the gaseous coating forming material 201 to reach to and flow out of an electrical discharging aera between the corresponding first electrode 311D and the second electrode 312D.

Correspondingly, the coating apparatus further includes a power supply arrangement 80 which includes an electrical power source 81 and an electrical connecting element 82 for electrically connecting the first electrode 311D to the electrical power source 81. Accordingly, the first electrodes 311D and the second electrodes 312D are positive and negative electrodes, and can be respectively electrically connected to two connecting ends of the electrical power source 81 such as an RF generator which is placed at an outer side of the chamber body 10. According to this embodiment, the first electrode 311D can be electrically connected to the electrical power source 81, and the second electrode 312D can be grounded.

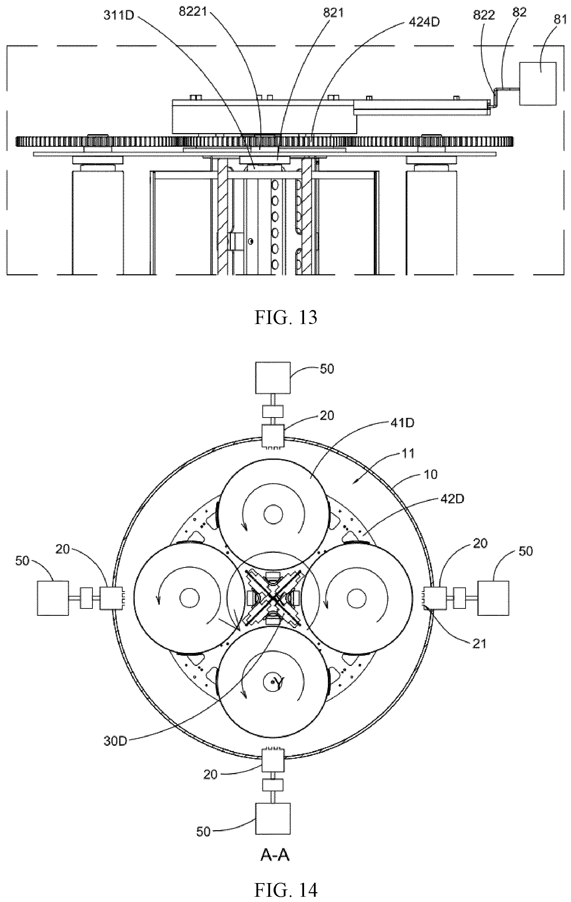

As shown in FIG. 13 of the drawings, the electrical connecting element 82 includes a first electrical connecting member 821 electrically connected to one of the first electrodes 311D and a second electrical connecting member 822 electrically connecting the first electrically connecting member 821 to the electrical power source 81. The second electrical connecting member 822 is fixed to the chamber body 10, the first electrical connecting member 821 is able to move along with the movable rack 42D when the movable rack 42D is driven to rotate.

Accordingly, the first electrical connecting member 821 is electrically connected to the second electrical connecting member 822 in such a manner that the first electrical connecting member 821 is movable respect to the second electrical connecting member 822. More specifically, when the movable rack 42D is driven to rotate, the first electrical connecting member 821 is rotating with respect to the second electrically connecting member 822. The electrical power source 81 at an outer side of the chamber body 11 is able to supply electrical power to the rotating first electrical connecting member 821.

A connecting end portion of the first electrical connecting member 821 can be embodied as a plate which is biased by a connecting end portion 8221 of the second electrical connecting member 822, an area of the plate is larger than an area of the connecting end portion 8221 of the second electrical connecting member 822. When the first electrical connecting member 821 is rotating along with the movable rack 42D, the connecting end portion 8221 of the second electrical connecting member 822 is kept to be attached on the connecting end portion of the first electrical connecting member 821, so as to ensure the electrical connection between the first electrical connecting member 821 and the second electrical connecting member 822.

Alternatively, the connecting end portion of the first electrical connecting member 821 can be embodied as an electrical sleeve which is sleeved around the connecting end portion 8221 of the second electrical connecting member 822, or the connecting end portion 8221 of the second electrical connecting member 822 can be embodied as an electrical sleeve which is sleeved around the connecting end portion of the first electrical connecting member 821.

The second electrical connecting member 822 can be movably connected to the chamber body 11 and is grounded. Alternatively, the second electrical connection member 822 can be connected or integrally extended from the movable rack 42D which is grounded.

When there are a plurality of first and second electrodes 311D and 312D, all of the first electrodes 311D can be electrically connected with each other, so that when one of the first electrodes 311D is electrically connected to the first electrical connecting member 821, all of the first electrodes 311D can be electrically connected to the electrical power source 81. All of the second electrodes 312D also can be electrically connected with each other to form an integral second electrode.

As shown in FIGS. 12 to 17 of the drawings, the coating apparatus further includes an actuator member 425D which is mounted to the top frame 421D. The actuator member 425D can be driven to rotate, so as to drive the movable rack 42D to rotate. It is worth mention that one more actuator member 42D can also be mounted to the bottom frame 422D for driving the movable rack 42D to rotate.

The actuator member 425 includes a mounting member 4251D mounted to the top frame 421D and an actuator shaft 4252D extended from the mounting member 4251D, the retention gear 424D has a central hole 4241D for the actuator shaft 4252D to pass therethrough and a retention hole 4242D for the connecting end portion 8221 of the second electrical connecting member 822 to pass therethrough, so that when the movable rack 42D is rotating, the retention gear 424D will also rotate, but the connecting end portion 8221 of the second electrical connecting member 822 penetrates through the retention gear 424D will block the movement of the retention gear 424D, the rotation gears 413D which are engaged with the retention gear 424D will rotate with respect to the retention gear 424D, so as to produce a relative movement between each of the carrier racks 41D and the movable rack 42D, so that an relative movement between each of the plurality of substrates 90 and the movable rack 42D is provided, and thus a relative movement between each of the plurality of substrates 90 and the plasma generation source 30D which is at the center of the movable rack 42D is also provided. Therefore, the plurality of substrates 90 are exposed in the reaction chamber 11 with a relatively even mixture of the monomer and the reactive precursor species, so as to enhance the uniformity and quality of the polymer coatings 92 formed on the surfaces 91 of the plurality of the substrates 90.

Similarly, the coating apparatus may further include other components, such as the monomer supply unit 50 for supplying the coating forming material 201 to the monomer discharge source 20, the pressure adjustment unit 60 which is adjacent to the plasma generation source 30D and remotely from the monomer discharge source 20 for adjusting a pressure in the reaction chamber 11 of the chamber body 10, the control unit for controlling the operation of the coating apparatus, and the tail gas tube for collecting a tail gas.

Accordingly, the present disclosure further provides a coating method for coating a plurality of substrates 90, wherein the coating method includes the following steps.
(i) Support the plurality of substrates 90 on the supporting rack 40D around the plasma generation source 30D which is provided at a central area 111 within the reaction chamber 11 of the chamber body 11.
(ii) Discharge the coating forming material 201 into the reaction chamber 11 of the chamber body 10 through the monomer discharge source 20 and activate the plasma generation source 30D to plasma processing the plurality of substrates 90.

Accordingly, in the Step (i), the method may further include a step of arranging the plurality of substrates between the monomer discharge source 20 and the plasma generation source 30D.

In the step (ii), the method may further include the steps of rotating the movable rack 42D about a central axis X thereof, rotating a plurality of carrier racks 41D for supporting the plurality of substrates about a central axis Y, and radially discharging the coating forming material 201 through a plurality of the monomer discharge sources 20 towards said plasma generation source 30D at the central area 111 within the reaction chamber 11 of the chamber body 10.

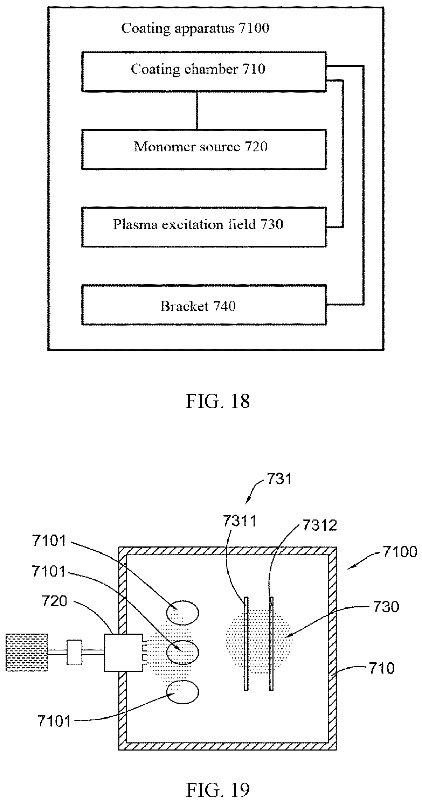

FIGS. 18 and 19 show a coating apparatus 7100 according to a fifth preferred embodiment of the present disclosure. The coating apparatus 7100 includes a coating chamber 710, at least one monomer source 720, and a plasma excitation field 730. The coating chamber 710 has a coating area 7101 for placing a substrate, the monomer source 720 is communicated with the coating chamber 710 and used for supplying a monomer to the coating chamber 710, and the plasma excitation field 730 is provided in the coating chamber 710 and used for activating a monomer. The plasma reaction 730 and the monomer source 720 are respectively located on two sides of the coating area 7101 to prepare a thin coating on a surface of the substrate. In this embodiment, the chamber body is implemented as the coating chamber 710, the monomer release source is implemented as the monomer source 720, and the plasma excitation source is implemented as the plasma excitation field 730.

During the coating process, a plasma environment is provide by passing a plasma source gas into the coating chamber 710, wherein the plasma excitation field 730 discharges to generate plasma, and wherein the gas monomer enters the plasma excitation field 730 through the coating area 7101 to be activated, so as to avoid the phenomenon of molecular chain structure being fragmented or excessively decomposed, etc. due to direct excessive activation of gas monomers in the plasma excitation field 730, so as to prepare a thin coating or coating with a relatively good property on the surface of the substrate. In other words, the gas monomer first diffuses into the coating area 7101, and then diffuses into the plasma excitation field 730, after being charged into the coating chamber 710. The plasma diffuses toward the coating area 7101. The gas monomer diffuses into the plasma excitation field 730 to be activated, and the activated gas monomer then diffuses to the coating area 7101 and is deposited on the surface of the substrate together with the unactivated gas monomer, to form a thin coating or coating with a relatively good property, and increase the deposition speed at the same time.

Further, the concentration of the gas monomer or monomer vapor diffusing along the radial direction of the coating area 7101 is gradually reduced, and in the same direction, the concentration of the plasma generated by discharge of the plasma excitation field 730 diffusing along the radial direction of the coating area 7101 is gradually increased, so that the concentration of the activated monomer is kept stable, so as to prepare a high-quality thin coating or coating on the surface of the substrate.

The coating apparatus 7100 applies the plasma chemical vapor deposition method to prepare the thin coating or coating on the surface of the substrate. That is, the thin coating is deposited and formed on the surface of the substrate, so as to improve the mechanical, optical or chemical properties of the surface of the substrate, wherein the substrate such as a product to be coated with a predetermined shape and structure, such as PCB circuit boards, mobile phones, electronic devices, electronic product covers, electronic product display screens, mobile phone glass screens, computer screens, mobile phone back covers, electronic equipment shells, keyboard coatings or mechanical parts, clothing and other types of products to be coated etc., is not limited thereto. For example, the coating apparatus prepares on an electronic product the thin coating, which is able to effectively improve waterproof, corrosion resistant, wear resistant and other protective properties of the product and solve the problem of high surface protection cost.

Optionally, the thin coating includes one or more layers of coatings, thin coatings, or nanocoatings, etc. coated on the surface of the substrate. Optionally, the thin coating or coating may be an inorganic thin coating, an organic thin coating, an organic silicon nano-protective coating, an organic silicon hard nano-protective coating, a composite structure high-insulation hard nano-protective coating, a high-insulation nano-protective coating with a modulated structure, a plasma polymerized coating, a gradient increasing structure liquid-proof coating, a gradient decreasing structure liquid-proof coating, a coating with controllable crosslinking degree, a waterproof and anti-puncture coating, a low adhesion and corrosion resistant coating, a liquid-proof coating with multi-layer structure, a polyurethane nanocoating, an acrylamide nanocoating, an anti-static liquid-proof nanocoating, an epoxy nanocoating, a high-transparency low-chromatic aberration nanocoating, a high-adhesion aging resistant nanocoating, a silicon-containing copolymer nanocoating, or a polyimide nanocoating, a diamond-like coating, etc., and is not limited herein. Alternatively, according to the definition of IPC, the coating or thin coating may be AR (acrylic), ER (epoxy), SR (organosilicon), UR (polyurethane), and XY (para-xylene) and other types of coatings or thin coatings. Further, paraxylene or parylene type coatings may provide relatively good chemical, electrical or physical protection.

The feed port of the monomer source 720 is communicated with the side of the coating chamber 710 close to the coating area 7101, that is, on the opposite side of the plasma excitation field 730, so as to ensure that the diffusion path of the gas monomer or monomer vapor is from the coating area 7101 to the plasma excitation field 730.

Optionally, the composition of the monomer is a mixture of at least one monofunctional unsaturated fluorocarbon compound and at least one multifunctional unsaturated hydrocarbon derivative or an organosilicon monomer containing a double bond, Si-Cl, Si-O-C, Si -N-Si, Si-O-Si structure or cyclic structure, the mass fraction of the polyfunctional unsaturated hydrocarbon derivatives in the monomer is 30-50%, wherein, the monofunctional unsaturated fluorocarbon compound includes 3-(perfluoro-5-methylethyl)-2-hydroxypropyl methacrylate, 2-(perfluorodecyl)ethyl methacrylate, 2-(perfluoroethyl)ethyl methacrylate, 2-(perfluorododecyl)ethyl acrylate, 2-perfluorooctyl ethyl acrylate, 1H, 1H, 2H, 2H-perfluorooctane alcohol acrylate, 2-(perfluorobutyl)ethylacrylate, (2H-perfluoropropyl)-2-acrylate, (perfluorocycloethyl)methacrylate, 3,3,3-trifluoro-1-propyne, 1-ethynyl-3,5-difluorobenzene, or 4-ethynyl trifluorotoluene. The polyfunctional unsaturated hydrocarbon derivative includes ethoxylated tricarboxymethyl propane triacrylate, tripropylene glycol diacrylate, divinylbenzene, polyethylene glycol diacrylate, 1,6-ethylene glycol diacrylate, ethylene glycol diacrylate, diethylene glycol divinyl ether, or neopentyl glycol diacrylate, and the multifunctional unsaturated hydrocarbon derivative includes polyethylene glycol diacrylate, ethylene glycol diacrylate, and diethylene glycol divinyl ether, ethoxylated trimethylolpropane triacrylate, tripropylene glycol diacrylate, 1,6-hexanediol diacrylate, or neopentyl glycol diacrylate.

Optionally, the monomer includes carbon-containing compounds with a reactive functional group, further includes substantially -CF3-based perfluoro compounds (see WO 97/38801), perfluoroolefins (see Wang et al., Chem Mater 1996, 2212-2214). Optionally, the monomer may also include hydrogen-containing unsaturated compounds containing a halogen atom or perhalogenated organic compounds containing at least 10 carbon atoms (see WO 98/58117), organic compounds containing two double bonds (see WO 99/64662), saturated organic compounds with an alkyl chain (optionally inserted with a heteroatom) of at least 5 carbon atoms (see WO 00/05000), alkynes (see WO 00/20130), polyether substituted olefins (see US6482531B), or macrocycles containing at least one heteroatom (see US6329024B).

Optionally, the thin coating is a diamond-like thin coating (DLC thin coating). The gas monomer for preparing the DLC thin coating is a reactive gas such as hydrogen, a hydrocarbon gas, or a dielectric material or an auxiliary gas of a doping element such as N, Si, F, B, etc. For example, the hydrocarbon gas is, such as, an alkane, an alkene, an alkyne, and the like, having a carbon atom number of 1-6 or more, not limited hereto. Optionally, the plasma excitation field 730 is located in the middle area or position of the coating chamber 710, wherein the feed port of the monomer source 720 may be located at a position of the surrounding sides of the coating chamber 710. The feed port may be multiple, and may be evenly arranged on the surrounding sides of the coating chamber 710, wherein the coating area 7101 is located between the middle position of the coating chamber 710 and the surrounding sides.

Optionally, the plasma excitation field 730 is located on one side of the coating chamber 710, wherein the feed port of the monomer source 720 is located on the opposite side of the coating chamber 710. Optionally, the gas source 720 and the plasma excitation field 730 may be arranged side by side with a certain distance therebetween, but not overlapping. Optionally, the coating chamber 710 may be circular, square or other shapes.

Further, the monomer source 720 is a feed source for a gas monomer or monomer vapor to go into the coating chamber, and may be communicated with a gas storage for storing the gas monomer in a gas state through a delivery pipeline, so as to pass the gas monomer in a gaseous state into the coating chamber 710. Alternatively, the monomer source 720 may be communicated with a liquid storage for storing a monomer in a liquid state through a delivery pipeline, wherein the monomer in a liquid state is vaporized by a gasification device (such as a heating device) to form a monomer vapor in a gas state, and is passed into the coating chamber 710 through the monomer source 720. Optionally, the storage may be a storage means for storing monomer raw materials, such as, a storage device, a storage bottle, or a storage tank.

The plasma excitation field 730 includes an electrode means 731, wherein the coating apparatus further includes a plasma source, wherein the plasma source is communicated with the coating chamber 710, and used for charging the coating chamber 710 with a plasma source gas, wherein the electrode means 731 is used to provide a radio frequency and/or pulse voltage to discharge the gas to generate a plasma environment. Further, the electrode means 731 and the monomer source 720 are located on two sides of the coating area 7101, respectively, so that the substrate in the coating area 7101 is not directly in the center of the plasma environment, that is, the substrate in the coating area 7101 is located at the edge area or position of the plasma environment generated by the plasma excitation field 730, so as to prevent the gas monomer on the surface of the substrate from being directly excessively activated in the center of the plasma excitation field 730, leading to phenomenons of fragmentation or excessive decomposition of the molecular chain structure, etc., and at the same time, to be capable of preparing a thin coating or coating with a good performance on the surface of the substrate.

The plasma source is communicated with a side of the coating chamber 710 close to the electrode means 731, so as to form the plasma excitation field 730 by discharging at the position of the electrode means 731, wherein the plasma source gas is a plasma source gas, such as, nitrogen, carbon tetrafluoride, or an inert gas such as helium or argon. Optionally, the plasma source is communicated with a pipeline for delivering a gas. Optionally, the plasma source is further communicated with a storage means for storing a plasma source gas.

Optionally, the discharge types of the electrode means 731 of the plasma excitation field 730 may be a discharge type such as direct current, alternating current, radio frequency, microwave, medium frequency, electric spark or pulse, and the like. For example, the mode in which the plasma excitation field 730 applies radio frequency discharge may be capacitive coupling and inductive coupling. For example, the mode in which the plasma excitation field 730 applies microwave discharge may be a resonant cavity, surface wave coupling, and electron cyclotron resonance. For example, the discharge mode of the plasma excitation field 730 may be continuous discharge or pulse discharge.

Preferably, the electrode means 731 includes a first electrode 7311 and a second electrode 7312, wherein a radio frequency voltage is provided between the first electrode 7311 and the second electrode 7312. For example, the electrode means 731 is used to provide a radio frequency voltage, wherein the first electrode 7311 is a radio frequency electrode, and is used to provide a radio frequency voltage, and the second electrode 7312 is a ground electrode. That is to say, the area between the first electrode 7311 and the second electrode 7312 generates a relatively strong RF voltage, while the RF voltage in the surrounding area is relatively low, that is, the coating area 7101 is located in a weak plasma environment to avoid excessive activation or decomposition of the gaseous monomer or monomer vapor, etc.

Further, the first electrode 7311 and the second electrode 7312 are facing each other and have a certain facing area, so as to form the plasma excitation field 730 with a certain space area, so that the plasma gas source gas discharges between the electrodes of the plasma excitation field 730 and generates plasma.

Further, the electrode means 731 further includes a pulse power supply, wherein the pulse power supply is provided in the coating chamber 710, wherein the pulse power supply is used to provide a pulse voltage to effect on the activated gas to accelerate the deposition rate, and improve the coating efficiency.

Optionally, the electrode means 731 is a microwave discharge electrode for generating a microwave discharge to effect on the plasma source gas to generate a plasma environment. Optionally, the electrode means 731 is a medium frequency discharge electrode for generating a plasma environment through medium frequency discharge. Optionally, the electrode means 731 is an electric spark discharge electrode for generating a plasma environment through electric spark discharge.

Further, the coating apparatus 7100 further includes a bracket 740, that is, the above support frame is implemented as the bracket 740 in this embodiment, wherein the bracket 740 is provided in the coating area 7101 for supporting the substrate. In this embodiment, the bracket 740 is detachably fixed to the coating area 7101, that is, the bracket 740 is fixed between the feed port of the monomer source 720 and the electrode means 731 of the plasma excitation field 730.

Further, the pulse power supply includes a positive electrode and a negative electrode, wherein the negative electrode is provided on the bracket 740 to provide a negative pulse voltage, wherein the positive electrode is connected to the coating chamber 710 and grounded to provide a positive pulse voltage, thereby accelerating the preparation rate of a thin coating on the surface of the substrate placed on the bracket 740.

Optionally, the bracket 740 may be a layered structure for placing the substrates in layers. Optionally, the bracket 740 may also be a ring bracket, a square bracket, a flat bracket, or a mesh bracket, and the like, not limited hereto.

Further, the coating apparatus 7100 further includes an air extraction means, wherein the air extraction means is communicated with an air extraction port of the coating chamber 710, for controlling the air pressure of the coating chamber 710 during the coating process. Optionally, the air extraction means is a dry pump, a molecular pump, or a Rhodes pump, or the like.

Further, this embodiment also provides a coating method for the coating apparatus 7100, including:
filling the coating chamber 710 with a gas monomer or monomer vapor, wherein the coating chamber 710 has the coating area 7101 for placing the substrate;
generating the plasma excitation field 730 within the coating chamber 710; and
entering the gas monomer or monomer vapor into the plasma excitation field 30 through the coating area 7101 to be activated, to prepare a thin coating on the surface of the substrate.

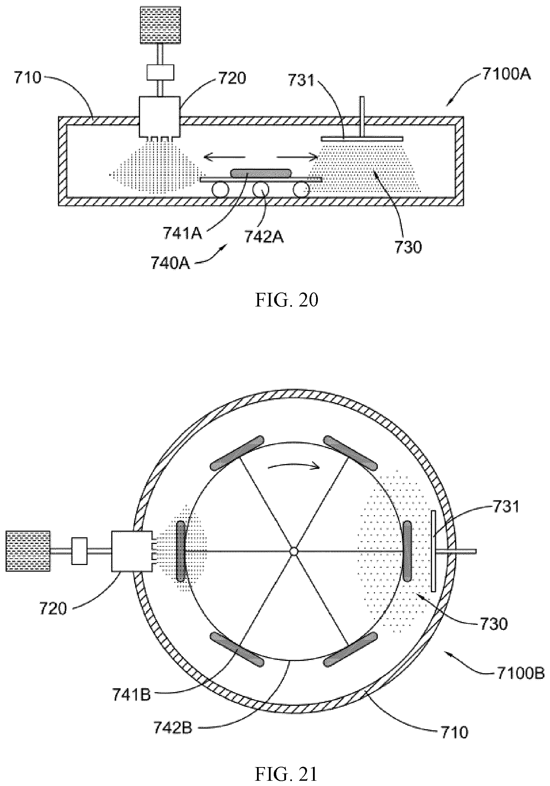

FIG. 20 shows a coating apparatus 7100A in a first variation embodiment of the present disclosure different from the preferred embodiments of the present disclosure in that, the coating apparatus 7100A includes a coating chamber 710, at least one monomer source 720, a plasma excitation field 730, and at least one bracket 740A, wherein the bracket 740A is provided in the coating chamber 710, wherein the bracket 740A has at least one support unit 741A for supporting a substrate, wherein the monomer source 720 is communicated with the coating chamber 710 for passing a gas monomer or monomer vapor into the coating chamber 710, wherein the plasma excitation field 730 is provided in the coating chamber 710 for activating the gas monomer or monomer vapor, wherein the support unit 741A of the bracket 740A may relatively reciprocate close to and away from the plasma excitation field 730, to prepare a thin coating on a surface of the substrate.

In this embodiment, the bracket 740A is movably provided in the coating chamber 710, wherein the support unit 741A of the bracket 740A is movably close to or away from the plasma excitation field 730. Optionally, there may be one or more support units 741A.

The feed port of the monomer source 720 is spaced apart from the plasma excitation field 730 at a certain distance, and does not overlap therewith, so as to provide an appropriate movement distance for the bracket 740A, and enable the support unit 741A to enter and exit the plasma excitation field 730.

In other words, in the coating chamber 710, the space area (the first space area) near the feed port of the monomer source 720 is filled with a large amount of a gas monomer or monomer vapor, and the space area (the second space area) near the electrode means 731 of the plasma excitation field 730 is filled with a large amount of the plasma source gas and discharges under the effect of a voltage to generate a large amount of plasma, so as to form a plasma environment. The first space area is adjacent to the second space area, wherein molecules in the first space area are mainly gas monomers or monomer vapors, and molecules in the second space area are mainly plasma, wherein the support unit 741A moves back and forth between the first space area and the second space area. It shall be understood that, the first space area and the second space area may have an overlapping area, but do not overlap completely.

The bracket 740A is a movable bracket for moving the substrate into and out of the plasma excitation field 730.

Specifically, the bracket 740A includes the support unit 741A and a movable unit 742A, wherein the support unit 741A is used to support the substrate, wherein the support unit 741A is connected to the movable unit 742A, and wherein the movable unit 742A may move within the coating chamber to approach and move away from the plasma excitation field 730. That is, in the above embodiments, the carrier frame is implemented as the support unit 741A, and the movable frame is implemented as the movable unit 742A.

Optionally, the movable unit 742A is a pulley or slideway structure. Optionally, the movable unit 742A is a retractable structure or the like.

Optionally, the plasma excitation field 730 is movably provided in the coating chamber 710, so that the bracket 740A is relatively close to and away from the plasma excitation field 730.

Further, the feed port of the monomer source 720 and the plasma excitation field 730 are located on two sides of the movement path of the bracket 740A. Further, the bracket 740A performs a reciprocating motion, wherein the support unit 741A of the bracket 740A moves back and forth between the plasma excitation field 730 and the feed port of the monomer source 720, to move the substrate repeatedly alternately approach the plasma excitation field 730 or the feed port of the monomer source 720. Optionally, the feed port of the monomer source 720 and the plasma excitation field 730 may be located on two sides of the coating chamber 710. Alternatively, the plasma excitation field 730 is located in the middle of the coating chamber 710, and the feed ports of the monomer source 720 are distributed on the surrounding sides of the coating chamber 710.

During the coating process, the feed port of the monomer source 720 continuously fills the coating chamber 710 with a gas monomer or monomer vapor, wherein the plasma excitation field 730 continuously releases a plasma source gas and provides a voltage for discharge to generate plasma, to form a plasma environment, wherein the support unit 741A of the bracket 740A reciprocates in and out of the plasma environment formed by the plasma excitation field 730. When the support unit 741A is close to the monomer source 720, the gas monomer or monomer vapor adheres to the surface of the substrate to form a thin layer, that is, the gas monomer or monomer vapor is adsorbed on the surface of the substrate. When the support unit 741A is close to the plasma excitation field 730, the gas monomer or monomer vapor adhered on the surface of the substrate is activated by the plasma. When the support unit 741A is close to the monomer source 720 again, the gas monomer or monomer vapor is grafted or polymerized with the activated molecules on the surface of the substrate, and the coating grows and thickens, and so on and so forth, until a thin coating or coating with a predetermined thickness is prepared on the surface of the substrate.

The difference between the present disclosure and the prior art is that, the prior art utilizes the plasma to effect on a gas monomer or monomer vapor in a space, wherein the gas monomer or monomer vapor molecules are completely exposed to the plasma, and decompose and generate various polymer products in the space, and then deposit on the surface of the substrate to prepare a thin coating or coating, resulting in low molecular integrity in and poor performance of the thin coating or coating; and in the present disclosure, the plasma generated by the plasma excitation field 730 effects only on the gas monomer or monomer vapor molecules adsorbed on the surface of the substrate, and then grafts or polymerizes with the gas monomer or monomer vapor molecules unaffected with the plasma to prepare a thin coating or coating, with high molecular integrity, so the performance of the thin coating or coating is better.

On the other hand, a portion of the monomer vapor diffuses into the plasma area, where it spatially decomposes and polymerizes and deposits on the surface of the substrate as it moves over, forming a part of a coating. This part of the polymer product has a higher degree of branching and crosslinking structure. The existence of a certain degree of branching and crosslinking in the coating is beneficial to improve the polymerization efficiency and the stability of the coating. The disclosure may conveniently control the branching and crosslinking proportion in the coating by adjusting the movement speed and residence time of the substrate between the monomer source and the plasma source, and obtain the best coating properties.

It is remarkable that, the movement path, movement speed, rhythm, residence time, cycle time, and movement time of the support unit 741A are all able to be preset to control the intermolecular branching and crosslinking proportion in the prepared coating, to ensure the performance, so as to be suitable for the preparation of the desired thin coating or coating, etc.

In this embodiment, the structural principles of the monomer source 720 and the plasma excitation field 730 are the same as those in this preferred embodiment, and are not described herein again.

Experiments show that, the uniformity and speed of the thin coating prepared by the coating apparatus of the present disclosure are improved compared with the existing coating apparatus. For example, under the condition that the feed rate of the gas monomer or monomer vapor is 300 uL/3000 seconds, the thicknesses (in Table 1 below) of the upper, middle and lower layers of the three types (Example 1, Example 2, Example 3) of the thin coatings prepared by the coating apparatus of the present disclosure and those (in Table 2 below) of the three types of the thin coatings prepared by the existing coating apparatus (Example 1, Example 2, Example 3) are compared in several groups as follows:

**Table 1 (thin coatings prepared by the coating apparatus of the present disclosure)**

| Thin coating | Example 1 | Example 2 | Example 3 |
|---|---|---|---|
| Thickness of the upper layer (nm) | 343 | 365 | 368 |
| Thickness of the middle layer (nm) | 351 | 371 | 366 |
| Thickness of the lower layer (nm) | 346 | 374 | 359 |

**Table 2 (thin coatings prepared by the existing coating apparatus)**

| Thin coating | Example 1 | Example 2 | Example 3 |
|---|---|---|---|
| Thickness of the upper layer(nm) | 225 | 247 | 209 |
| Thickness of the middle layer (nm) | 203 | 187 | 231 |
| Thickness of the lower layer(nm) | 162 | 235 | 158 |

It can be seen that, the thicknesses and speeds of the thin coatings prepared by the coating apparatus of the present disclosure are increased by 1.5-2 times compared with those of the existing coating apparatus, the thickness deviations between the upper layers, the middle layers and the lower layers of the thin coatings are relatively low, and the uniformity is high.

FIG. 21 shows a coating apparatus 7100B of a second variation embodiment of the present disclosure. It differs from those in the above embodiments in that, the coating apparatus 7100B of this second variation embodiment includes a coating chamber 710, at least one monomer source 720, a plasma excitation field 730, and at least one bracket 740B, wherein the bracket 740B is provided in the coating chamber 710 and has at least one support unit 741B for supporting a substrate, wherein the monomer source 720 is communicated with the coating chamber 710 for feeding a gas monomer or monomer vapor into the coating chamber 710, wherein the plasma excitation field 730 is provided in the coating chamber 710 for activating the gas monomer or monomer vapor, wherein the support unit 741B of the bracket 740B may relatively reciprocate close to and away from the plasma excitation field 730 to prepare a thin coating on a surface of the substrate.

Further, the bracket 740B is rotatably provided in the coating chamber 710, and as the bracket 740B rotates, the support unit 741B reciprocates close to or away from the plasma excitation field 730. That is, the bracket 740B is a rotatable structure.

Specifically, the bracket 740B includes the support unit 741B and a rotatable unit 742B, wherein the support unit 741B is connected to the rotatable unit 742B, wherein the rotatable unit 742B is rotatably installed to the coating chamber 710, with the rotation of the rotatable unit 742B, the support unit 41B reciprocally approaches or moves away from the plasma excitation field 730.

Further, there are multiple support units 741B, and the various support units 741B are arranged in a ring on the rotatable unit 742B, wherein the rotatable unit 742B of the bracket 740B is located between the plasma excitation field 730 and the feed ports of the monomer source 720, with the rotation of the rotatable unit 742B of the bracket 740B, the various support units 741B are alternately reciprocating between the space area (the first space area) adjacent to the feed ports of the monomer source 720 and the space area (the second space area) near the plasma excitation field 730 in turn.

It shall be understood that, the rotation axis of the rotatable unit 742B is the middle position of the coating chamber 710, wherein the plasma excitation field 730 is located on one side of the coating chamber 710, and wherein the monomer source 720 is located on another side of the coating chamber 710 and does not coincide with the plasma excitation field 730.

During the coating process, when the support unit 741B is close to the feed port of the monomer source 720, that is, enters the first space area, the gas monomer or monomer vapor adheres to the surface of the substrate to form a thin coating, i.e., the gas monomer or monomer vapor is adsorbed on the surface of the substrate. When the support unit 741B is close to the plasma excitation field 730, that is, enters the second space area, the gas monomer or monomer vapor attached to the surface of the substrate is activated by the plasma. When the support unit 741B approaches the monomer source 720 again, that is, enters the first space area, the gas monomer or monomer vapor is grafted or polymerized with the activated molecules on the surface of the substrate, and the coating grows and thickens, and this is repeated continuously, until a thin coating or coating with a predetermined thickness is prepared on the surface of the substrate.

That is to say, the bracket 740B performs a circular motion or elliptical motion, wherein each of the substrates is located at the circumferential position of the bracket 740B, so as to reciprocate circular motion or elliptical motion along with the bracket 740B, and alternately enter and exit the plasma excitation field 730 in a circular motion or elliptical motion.

It is remarkable that, the rotation speed, rhythm, cycle time of the rotatable unit 742B, the rotation radius of the support unit 741B, and the residence time in each of the first space area and the second space area are all able to be predetermined, to control and adjust the proportion of intermolecular branching and crosslinking in the prepared coating to ensure the performance, so as to be suitable for preparing a desired thin coating or coating with good performance.

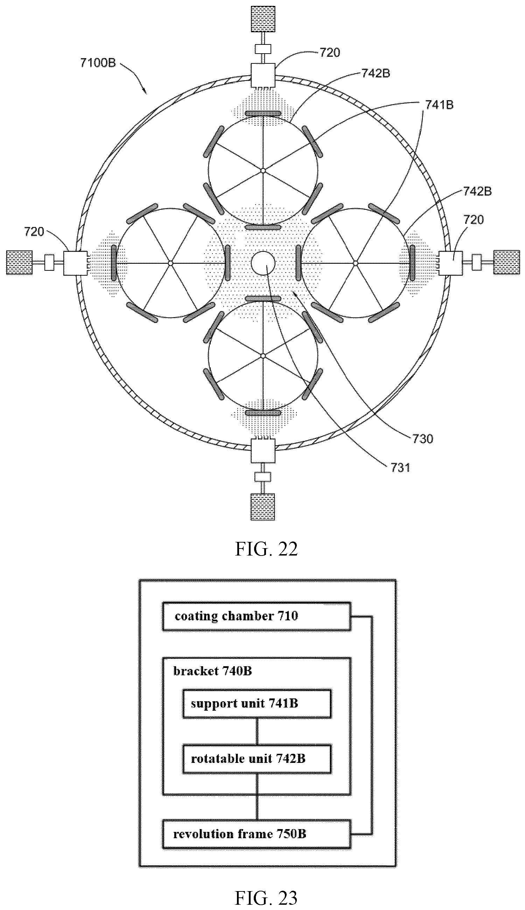

FIGS. 22 and 23 show a variant implementation of the second variation embodiment of the present disclosure, wherein the plasma excitation field 730 is located in the middle position of the coating chamber 710, wherein a plurality of the monomer sources 720 are respectively located on the surrounding sides of the coating chamber 710, wherein a plurality of the brackets 740B are respectively located between the monomer source 720 and the plasma excitation field 730 correspondingly, and wherein the various brackets 740B do not interfere with each other. That is to say, the middle area of the coating chamber 710 is the second space area, and is full of a large amount of plasma, wherein the surrounding area of the coating chamber 710 is the first space area, and is full of a large amount of gas monomer or monomer vapor molecules, wherein the various brackets 740B is arranged in a ring in the coating chamber 710, and the support units 741B of each of the brackets 740B alternately move between the first space area and the second space to realize coating in bulk.

Further, the electrode means 731 of the plasma excitation field 730 is provided at a middle position of the coating chamber 710, wherein the electrode means 731 is a columnar structure, wherein the electrode means 731 is located in the middle of the various brackets 740B, wherein the support units 741B of each of the brackets 740B rotate around the axis of the electrode means 731. The first electrode 7311 of the electrode means 731 is juxtaposed with the second electrode 7312, wherein the first electrode 7311 is a radio frequency electrode, and wherein the second electrode 7312 is grounded. Further, the first electrode 7311 may be a plurality of columnar structures with right-angled cross sections arranged in a ring, or a structure of other shapes, not limited hereto. The gas suction port of the coating chamber 710 is located above or below the electrode means 731 for exhausting the gas in the coating chamber 710 during the coating process.

Optionally, the electrode means 731 of the plasma excitation field 730 is provided at a middle position of the coating chamber 710, wherein an air extraction column is provided at a middle position of the coating chamber 710, wherein the side wall of the air extraction column is provided with an exhaust hole to communicate with the outside world, and the air extraction column is connected to an air extraction means to exhaust the gas in the coating chamber 710 and control the air pressure. The second electrode 7311 of the electrode means 731 is electrically connected to the air extraction column and grounded, wherein the first electrode 7312 is provided outside the air extraction column to serve as a radio frequency electrode.

Optionally, the air extraction column serves as the second electrode 7312 of the electrode means 731 and is grounded, wherein the first electrode 7311 is provided outside the air extraction column, and wherein the first electrode 7311 may be a cylindrical columnar structure so as to be sleeved on the outside of the air extraction column. A side wall of the first electrode 7311 has a plurality of through-holes to ensure the discharge rate of the gas in the coating chamber 710 from the air extraction column.

Optionally, the first electrode 7311 of the electrode means 731 may be provided on the bracket 740B, and the second electrode 7312 is electrically connected to the air extraction column and grounded, so that the air extraction column acts as the second electrode. For example, the bracket 740B includes an electrode element made of a conductive material, wherein the electrode element is electrically connected to the first electrode 7311, or the bracket 740B is made of a conductive material and is electrically connected to the first electrode 7311.

Further, the coating chamber 710 is a cylindrical structure.

As shown in FIG. 23, further, the coating apparatus 7100B further includes a revolution frame 750B, wherein the revolution frame 750B is rotatably provided in the coating chamber 710 and takes the center of the coating chamber 710 as an axis, and wherein the rotatable units 742B of each of the brackets 70B are installed on the revolution frame 750B in a ring, and rotate with the rotation of the revolution frame 750B, that is, the brackets 740B takes the center of the coating chamber 710 as an axis to revolve.

Optionally, the rotation axis of the rotatable unit 742B is located at a position of a half radius of the coating chamber 710, wherein each of the brackets 740B rotates around its own axis. And, during the rotation process, the substrate supported by each of the support units 741B moves alternately between the first space area and the second space area, respectively, to realize coating.

That is to say, the bracket 740B and the revolution frame 750B drive each of the substrates to perform planetary motion or planetary-like motion, wherein the plasma excitation field 730 is provided on the path where the substrate passes through, so that each of the substrates alternately enters and exits the plasma excitation field 730.

It is remarkable that, the revolution speed of the revolution frame 750B may be preset, wherein the revolution radius of the bracket 740B may be preset. Further, the revolution and rotation speed ratio and the revolution and rotation revolution ration between the revolution frame 750B and the bracket 740B are all able to be preset, so as to adjust the residence time or movement speed or the like of the substrate in the first space area or the second space area, to control the coating.

Optionally, the bracket or structure for supporting and moving the substrate is implemented as a structure capable of spherical motion, so as to support and drive each of the substrates to perform spherical motion in the coating chamber 710, wherein the plasma excitation field 730 is provided in a local area of the spherical surface to be located on a path that the substrate passes through, so that the substrate alternately enters and exits the plasma excitation field 730.

Optionally, the bracket or structure for supporting and moving the substrate is implemented as a structure capable of swing back and forth, so as to support and drive each of the substrates to swing back and forth in the coating chamber 710, wherein the plasma excitation field 730 is provided on the swing path, so that the substrate enters and exits the plasma excitation field 730 back and forth by swing.

It will be understood by those skilled in the art that, the bracket or structure for supporting the substrate may be fixed to the coating chamber, wherein the plasma excitation field is implemented to be movable, wherein the electrode means of the plasma excitation field moves in the coating chamber 710 through a movable structure, so that the substrate enters and exits the plasma excitation field relatively. Said movable structure may be a reciprocating motion structure, swing back and forth structure, circular motion structure, spherical motion structure, planetary motion structure, etc., and is not limited hereto.

Further, the present disclosure also provides a coating method for the coating apparatus, including:
filling the coating chamber with a gas monomer or monomer vapor;
forming the plasma excitation field within the coating chamber; and
moving or rotating the bracket relatively close to or away from the plasma excitation field, wherein the bracket is used for supporting a substrate to prepare a thin coating on a surface of the substrate.

It should be understood by those skilled in the art that, the embodiments of the present disclosure shown in the above description and the accompanying drawings are only examples and do not limit the present disclosure. The objects of the present disclosure have been fully and effectively achieved. The functional and structural principles of the present disclosure have been shown and explained in the embodiments, and any variations or modifications of the embodiments of the present disclosure are possible without departing from the principles.

## Claims

1. A coating apparatus for coating a plurality of substrates, comprising:
a chamber body having a reaction chamber;
a monomer discharge source having a discharge inlet for introducing a coating forming material into said reaction chamber of said chamber body;
a plasma generation source disposed at a central area of said reaction chamber of said chamber body for exciting the coating forming material; and
a supporting rack for supporting the plurality of substrates around said plasma generation source within said chamber body.

2. The coating apparatus according to claim 1, wherein said monomer discharge source is spacedly apart from said plasma generation source in such a manner that the plurality of substrates is adapted for being arranged between said monomer discharge source and said plasma generation source.

3. The coating apparatus according to claim 1, wherein said reaction chamber has the central area, wherein said plasma generation source is disposed at said central area of said reaction chamber, wherein said supporting rack mounted to said chamber body, wherein said supporting rack is adapted for supporting the plurality of substrates between said monomer discharge source and said plasma generation source.

4. The coating apparatus according to claim 1, wherein said supporting rack is operable to move in said reaction chamber of said chamber body between said monomer discharge source and said plasma generation source.

5. The coating apparatus according to claim 1, wherein said plasma generation source is mounted to said supporting rack, wherein said supporting rack is operable to move in said reaction chamber of said chamber body to drive said plasma generation source to move in said reaction chamber.

6. The coating apparatus according to claim 1, wherein said plasma generation source is mounted to said chamber body, wherein said supporting rack is operable to rotate in said reaction chamber of said chamber body around said plasma generation source.

7. The coating apparatus according to claim 1, wherein said supporting rack comprises a carrier rack for supporting the plurality of substrates, wherein said carrier rack is operable to rotate about a central axis thereof around said plasma generation source.

8. The coating apparatus according to claim 1, wherein said supporting rack comprises a movable rack which is operable to move in said chamber body and a carrier rack for supporting the plurality of substrates, wherein said carrier rack is arranged on said movable rack and is operable to move in said chamber body to produce a relative movement between said movable rack and said carrier rack.

9. The coating apparatus according to claim 1, wherein said supporting rack comprises a movable rack which is operable to rotate about a central axis thereof and a carrier rack for supporting the plurality of substrates, wherein said carrier rack is arranged on said movable rack and is operable to rotate about a central axis thereof around said plasma generation source.

10. The coating apparatus according to claim 5, wherein said supporting rack comprises a movable rack which is operable to move in said chamber body and a carrier rack for supporting the plurality of substrates, wherein said carrier rack is arranged on said movable rack and is operable to move in said chamber body to produce a relative movement between said movable rack and said carrier rack.

11. The coating apparatus according to claim 5, wherein said supporting rack comprises a movable rack which is operable to rotate about a central axis thereof and a carrier rack for supporting the plurality of substrates, wherein said carrier rack is arranged on said movable rack and is operable to rotate about a central axis thereof around said plasma generation source.

12. The coating apparatus according to claim 3, wherein said supporting rack comprises a movable rack which is operable to rotate about a central axis thereof and a carrier rack for supporting the plurality of substrates, wherein said carrier rack is arranged on said movable rack and is operable to rotate about a central axis thereof around said plasma generation source.

13. The coating apparatus according to claim 12, wherein said movable rack comprises a top frame, a bottom frame, and a plurality of connectors extended between said top frame and said bottom frame, wherein said supporting rack comprises a plurality of said carrier racks supported between said top frame and said bottom frame.

14. The coating apparatus according to claim 12, wherein said carrier rack comprises a supporting arm, two retention arms extended from said supporting arm respectively, and one or more supporting seats extended between said two retention arms for supporting the plurality of substrates.

15. The coating apparatus according to claim 13, wherein each of said carrier racks further comprises a retention gear supported on said top frame, wherein each of said carrier racks comprises a rotation gear which is engaged with said retention gear.

16. The coating apparatus according to claim 15, wherein each of said carrier racks comprises a supporting arm, two retention arms extended from said supporting arm respectively, and a plurality of supporting seats extended between said two retention arms for supporting the plurality of substrates, wherein said rotation gear is mounted on a top of said supporting arm.

17. The coating apparatus according to claim 12, wherein said plasma generation source comprises a first electrode and a second electrode functioning as a pair of opposite electrodes for applying an electric power to the coating forming material discharged into said reaction chamber, wherein said coating apparatus further comprises a power supply arrangement which comprises an electrical power source and an electrical connecting element for electrically connecting said first electrode to said electrical power source.

18. The coating apparatus according to claim 17, wherein said electrical connecting element comprises a first electrical connecting member electrically connected to said first electrode and a second electrical connecting member connected to said electrical power source, wherein said first electrical connecting member is rotatably and electrically coupled with said second electrical connecting member.

19. The coating apparatus according to claim 15, wherein said plasma generation source comprises a first electrode and a second electrode functioning as a pair of opposite electrodes for applying an electric power to the coating forming material discharged into said reaction chamber, wherein said coating apparatus further comprises a power supply arrangement which comprises an electrical power source and an electrical connecting element for electrically connecting said first electrode to said electrical power source.

20. The coating apparatus according to claim 19, wherein said electrical connecting element comprises a first electrical connecting member electrically connected to said first electrode and a second electrical connecting member connected to said electrical power source, wherein said first electrical connecting member is rotatably and electrically coupled with said second electrical connecting member.

21. The coating apparatus according to claim 20, wherein said second electrical connecting member has a connecting end portion penetrating through said retention gear to block a rotation movement of said retention gear, wherein said rotation gear which is engaged with said retention gear is capable of rotating with respect to said retention gear, so as to produce a relative movement between each of said carrier racks and said movable rack.

22. The coating apparatus according to claim 21, wherein said movable rack further comprises an actuator member which is mounted to said top frame for being actuated to drive said movable rack to rotate, wherein said actuator member comprises a mounting member mounted to said top frame and an actuator shaft extended from said mounting member, wherein said retention gear has a central hole for said actuator shaft to pass therethrough and a retention hole for said connecting end portion of said second electrical connecting member to pass therethrough.

23. The coating apparatus according to claim 1, wherein said chamber body has an inner wall, wherein said coating apparatus comprises a plurality of said monomer discharge sources provided adjacent to said inner wall for radially dispersing the coating forming material into said reaction chamber.

24. The coating apparatus according to claim 1, wherein an electrical discharge manner of said plasma generation source is selected from the group consisting of a direct current discharge, an alternating current discharge, an audio frequency discharge, a radio frequency discharge, a microwave discharge, a medium frequency discharge, a penning discharge, a spark discharge and a pulse discharge.

25. The coating apparatus according to claim 1, wherein said coating apparatus further comprise a monomer supply unit which comprises a material storage member for storing a raw material of the coating forming material, a vaporizer for vaporizing the raw material to form the coating forming material which is a monomer vapor.

26. The coating apparatus according to claim 1, wherein said coating apparatus further comprise a monomer supply unit which comprises a material storage member, which is communicated to said monomer discharge source, for storing the coating forming material which is a gaseous monomer.

27. A coating method for coating a plurality of substrates, comprising the following steps:
(I) arranging a plasma generation source at a central area of a reaction chamber of a chamber body;
(II) placing the plurality of substrates around said plasma generation source; and
(III) discharging a coating forming material into said reaction chamber of said chamber body through a monomer discharge source and activating said plasma generation source to plasma processing the plurality of substrates.

28. The method according to claim 27, further comprising a step of moving the plurality of substrates around said plasma generation source.

29. The method according to claim 27, further comprising a step of radially discharging the coating forming material through a plurality of said monomer discharge sources towards said plasma generation source, wherein the plurality of substrates are arranged between said monomer discharge sources and said plasma generation source.

30. A coating method for coating a plurality of substrates, comprising the following steps:
(i) supporting the plurality of substrates on a supporting rack around a plasma generation source which is provided at a central area within a reaction chamber of a chamber body; and
(ii) discharging a coating forming material into said reaction chamber of said chamber body through a monomer discharge source and activating said plasma generation source to plasma processing the plurality of substrates.

31. The method according to claim 30, further comprising a step of placing the plurality of substrates between said monomer discharge source and said plasma generation source.

32. The method according to claim 30, wherein said plasma generation source is mounted to said chamber body.

33. The method according to claim 30, wherein said plasma generation source is mounted to said supporting rack.

34. The method according to claim 30, further comprising the steps of rotating a movable rack of said supporting rack about a central axis of said chamber body, and rotating a plurality of carrier racks, wherein each of said carrier racks, which is supported on said movable rack for carrying the plurality of substrates, is rotating along with said movable rack and is operable to rotate about its central axis.
